# EUROPÄISCHE PATENTSCHRIFT

(11) **EP 2 577 721 B1**
(45) Veröffentlichungstag und Bekanntmachung des Hinweises auf die Patenterteilung: **22.02.2017**
(21) Anmeldenummer: 11729389.4
(22) Anmeldetag: 01.06.2011
(51) Int. Cl.: H01L 31/18, H01L 21/67, B32B 17/10

(54) **FERTIGUNGSEINRICHTUNG UND VERFAHREN**
PRODUCTION DEVICE AND METHOD
DISPOSITIF DE PRODUCTION ET PROCÉDÉ

(30) Priorität: 31.08.2010 DE 202010008418 U; 02.06.2010 DE 202010005555 U
(43) Veröffentlichungstag der Anmeldung: 10.04.2013
(73) Patentinhaber: KUKA Systems GmbH, 86165 Augsburg (DE)
(72) Erfinder: ALBRECHT, Dirk, 16833 Fehrbellin (DE); LIEPERT, Jürgen, 86447 Eisingersdorf (DE); BÜCHLER, Michael, 86179 Augsburg (DE); HUBER, Rudolf, 81245 München (DE); KUGLER, Thomas, 86551 Aichach (DE); KIEMSTEDT, Peter, 86453 Dasing (DE)
(74) Vertreter: Ernicke, Klaus Stefan
(86) Internationale Anmeldenummer: PCT/EP2011/059165
(87) Internationale Veröffentlichungsnummer: WO 2011/151430

(56) Entgegenhaltungen:
- EP-A1- 0 415 340
- EP-A2- 1 498 933
- WO-A2-03/069682
- JP-A- 2000 349 136
- JP-A- 2002 083 992
- JP-A- 2004 022 997
- JP-A- 2005 026 377
- US-A- 3 565 719
- US-A- 5 252 850
- US-A1- 2001 026 349
- US-A1- 2008 132 033
- US-A1- 2008 138 936
- US-A1- 2008 279 659

## Beschreibung

Die Erfindung betrifft eine Fertigungseinrichtung und ein Fertigungsverfahren für mehrschichtige Module, insbesondere Solarmodule.

Eine solche Fertigungseinrichtung und ein Fertigungsverfahren sind aus der DE 10 2007 038 240 A1 bekannt. Auf einen Gießtisch mit Saugöffnungen werden Solarzellen aufgelegt und mit Unterdruck festgehalten. Im Bereich unterhalb der aufgelegten Solarzellen sind am Gießtisch Saugöffnungen gebildet, um die Solarzellen mittels Unterdruck auf dem Gießtisch festzuhalten. Der Gießtisch wird anschließend unter einer Gießvorrichtung an einem Portal verfahren, aus der ein fließfähiges Verbindungsmaterial in Form eines Polyolefin-Plastisols auf die Solarzellen aufgebracht wird. Hierbei wird die Anordnung von Solarzellen mit einer äußeren Schicht beschichtet. Dies geschieht mittels eines sogenannten Vorhanggießens oder Rakelns, so dass die Anordnung von Solarzellen beim Hindurchfahren unter der Gießvorrichtung breitflächig beschichtet wird. Im nächsten Schritt führt ein Roboter eine Glasplatte zu. Die Glasplatte wird hierbei mittels höhenverstellbare Saughalter bogenförmig und blasenfrei auf die zuvor erzeugte und die Anordnung von Solarzellen erfassende Beschichtung aufgelegt bzw. abgerollt. Durch das allmähliche - bogenförmige - Ablegen der Glasplatte wird eine Blasenbildung zwischen der Polyolefin-Plastisol-Schicht und der Glasplatte verhindert. Das hierdurch gebildete dreilagige Modulelement wird mit einem Förderer weiter zu einer Heizvorrichtung und einer Wendevorrichtung transportiert, wobei anschließend mit einer Glasplattendoubliervorrichtung eine Deckschicht in Form einer zweiten Glasplatte nebst eines Klebstoffs aufgebracht wird und das fertige Modul in einer Heizeinrichtung fixiert und der Klebstoff ausgehärtet wird.

Die EP 1 0302 988 A2 lehrt ebenfalls eine Fertigungseinrichtung und ein Fertigungsverfahren zur Herstellung eines mehrschichtigen Solarmoduls mit eingebetteten Solarzellen unter Einsatz einer Wölbungseinrichtung für eine plattenartige lichtdurchlässige Schicht. Die Wölbungsvorrichtung ist in diesem Fall Bestandteil eines Rollenlaminators.
Die US 2003/0005954 A1 befasst sich mit der Bildung gewölbter mehrschichtiger Solarmodule, wobei auch eine Glasplatte gewölbt wird. Dies geschieht durch Erwärmung einer ebenen Glasplatte über einem Gesenk, die sich dann durch ihr Eigengewicht in das Gesenk verformt und dessen Wölbung annimmt. Die Wölbung wird beibehalten und nicht wieder aufgehoben.

Die US 2001/026346 A1 offenbart eine Fertigungseinrichtung, bei der Flüssigkristalle zwischen transparenten Substraten eingebettet werden.

Es ist Aufgabe der vorliegenden Erfindung, eine verbesserte Fertigungstechnik für mehrschichtige Module, insbesondere Solarmodule sowie deren Basiskomponenten aufzuzeigen.

Die Erfindung löst diese Aufgabe mit den Merkmalen in den selbstständigen Ansprüchen 1 und 9. Vorteilhafte Ausgestaltungen der Erfindung sind Gegenstand von abhängigen Unteransprüchen.

Die beanspruchte Fertigungstechnik hat verschiedene Vorteile. Durch eine besonders gut steuerbare und relaxierbare Wölbung von einer plattenartigen Schicht, insbesondere einem Träger des mehrschichtigen Solarmoduls, kann eine noch gleichmäßigere und sicherere Verteilung einer nachgiebigen Verbindungsmasse, insbesondere in pastöser oder flüssiger Form, erzielt werden. Durch ein gegenseitiges Andrücken der zu verbindenden Schichten und die Relaxation der Wölbung kann ein Wälz- und Verteileffekt auf die zuvor aufgebrachte Verbindungsmasse erzielt werden. Durch die Verdrängung der Verbindungsmasse kann auch ein allseitiges Einbetten und Umschließen des solaraktiven Elements begünstigt werden.

Eine mechanische Biegung und Wölbung einer plattenartigen Schicht, insbesondere einer durchsichtigen Glas- oder Kunststoffplatte, durch eine Hebe- und Senkbewegung eines Drückelements ist besonders gut und sicher steuerbar. Die Wölbung kann dabei im Bereich einer vorzugsweise stationären Auflage und nahe an der Applikations- und Verbindungsstelle gebildet werden. Die Wölbung kann sich durch die Eigenelastizität der plattenartigen Schicht und ein Nachgeben des Drückelements relaxieren. Der Vorgang kann durch ein Andrückelement, z.B. eine drehbare und entlang der plattenartigen Schicht bewegte Walze, unterstützt werden, wobei auch ein Anpressdruck zur besseren und innigen Schichtenverbindung entwickelt werden kann. Der Vorschub des Andrückelements kann dabei mit der Rückwärts- oder Absenkbewegung des Drückelements abgestimmt werden, was für einen gesteuerten Abwälzvorgang zur gleichmäßigen Verteilung des bevorzugt flüssigen oder pastösen Verbindungsmaterials und zur Austreibung von Luftresten günstig ist. Eine solche Wölbungseinrichtung lässt sich besser und genauer steuern als eine bewegliche Saugeinrichtung, zumal der Abwälzvorgang gleichmäßiger als bei voneinander beabstandeten Saughaltern wie beim Stand der Technik ist. Zudem ist die Druckentwicklung besser, höher und gleichmäßiger.

Die beanspruchte Fertigungstechnik hat ferner den Vorteil, dass das gesamte Solarmodul in einer Station und an einer Auflage komplett hergestellt werden kann. Alternativ ist auch eine Fertigungsstraße mit mehreren aufeinander folgenden Stationen zur Durchführung der Einzelschritte möglich.

Vorteilhaft ist ferner, dass fertige Solarelemente, insbesondere Strings oder komplette Solarzellenanordnungen, mit bereits angebrachten Verbindungsleitungen appliziert und zwischen den anderen Modulschichten eingebettet werden können. Hierfür kann auch eine Führungseinrichtung an der Auflageplatte eines Tischs mit Nuten oder dgl. zur exakten Positionierung und Fixierung, insbesondere mittels ggf. steuerbarem Saugdruck, vorteilhaft sein.

Die gleiche Wölb- und Wälztechnik kann für verschiedene plattenartige Schichten, insbesondere für eine vordere und hintere Glasscheibe, eingesetzt werden. In ähnlicher Weise kann auch als Deckschicht eine flexible Rückenfolie oder dgl. mit einer Wölbung appliziert werden.

Günstig ist ferner, dass wahlweise eine Verbindungsschicht aus einem flüssigen oder pastösen oder folienartigen Verbindungsmaterial auf einem oder mehreren Solarelement(en) oder auf einer plattenartigen Schicht, insbesondere einer Glasplatte, appliziert werden kann. Ferner ist es aus Gründen der Prozesssicherheit von Vorteil, die verschiedenen Verarbeitungsschritte an einer stationären und tischförmigen Auflage vornehmen zu können. Dies ist v.a. mit Hinblick auf die Positioniergenauigkeit einer Handhabungseinrichtung von Vorteil. Zudem kann eine der Auflage zugeordnete Auftrag- und Dosiereinrichtung exakter und mit höher Reproduzierbarkeit das besagte Verbindungsmaterial aufbringen.

Die Zuführung der verschiedenen Schichten kann mittels einer geeigneten Handhabungseinrichtung, insbesondere eines mehrachsigen Manipulators, vorzugsweise eines Gelenkarmroboters, durchgeführt werden. Die Handhabungseinrichtung kann dabei ggf. auch einen Anpressdruck entwickeln.

Durch die Handhabungseinrichtung können auch die Handhabungsvorgänge innerhalb der Fertigungseinrichtung vereinfacht und beschleunigt werden. Über eine solche Handhabungseinrichtung können außerdem Zusatzfunktionen bei Bedarf ausgeführt werden, insbesondere eine Kontrolle und Prüfung von solaraktiven Elementen und deren Verbindung sowie ggf. die Herstellung einer solchen elektrisch leitenden Verbindung mittels Löten oder dgl..

Die lichtdurchlässige plattenartige Schicht, insbesondere der besagte Träger, mit einem über die Verbindungsmasse eingebetteten und verbundenen solaraktiven Element kann eine Basiskomponente für die Herstellung unterschiedlicher Typen von Solarmodulen darstellen. Die hierfür eingesetzte Fertigungstechnik kann immer die gleiche sein, sodass nach der Art eines Baukastensystems große Stückzahlen und eine hohe Wirtschaftlichkeit erreichbar sind. Die weiteren Fertigungsvorgänge können modulspezifisch sein und sich nach der Art der solaraktiven Elemente richten.

Für die weiteren Fertigungsschritte ist es außerdem von Vorteil, eine Applikationstechnik und eine Aufbringvorrichtung einzusetzen, die auch eine oder mehrere weitere Schichten mit Hilfe eines Wälzprozesses auf der Basiskomponente aufbringt. Hierbei kann z.B. eine biegeelastische Deckschicht in Folienform aufgewälzt werden, wobei im Wälzzwickel oder Wälzspalt ein fluidischer Klebstoff eingebracht und zugleich verteilt wird.

Die Verbindungsmasse zum Einbetten von solaraktiven Elementen, insbesondere Solarzellen oder Hybridanordnungen, hat den Vorteil, dass sie die EVA-Folien ersetzen und eine sichere sowie lichtdurchlässige Verbindung zwischen einem transparenten Träger und einer Schicht von mindestens einem solaraktiven Element, z.B. einer photoaktiven Solarzelle oder einer Hybridanordnung, bilden kann. Die eine oder mehreren solaraktiven Elemente können in die Verbindungsmasse eingebettet und von dieser mehrseitig umschlossen werden. Dies sorgt auch für eine Abdichtung der solaraktiven Elemente gegenüber Umgebungseinflüssen, insbesondere Luft- und Feuchtigkeitszutritt. Dies ist vor allem an den Randbereichen des Solarmoduls von Vorteil, die sich besser als bisher abdichten und versiegeln lassen.

Die Verbindungsmasse ist anfangs nachgiebig und kann ausweichen oder komprimiert werden, wofür z.B. eine pastöse oder flüssige Konsistenz von Vorteil ist. Aber auch kompressible Folien sind einsetzbar. Nach der Einbettung des oder der solaraktiven Elemente kann sich die Verbindungsmasse verfestigen, indem sie z.B. aushärtet, was durch Komponentenreaktion eines mehrkomponentigen Materials, durch Lichtaushärtung oder auf andere Weise möglich ist. Durch die Verfestigung wird der gesamte Schichtenverbund stabilisiert und der Verbindungseffekt, insbesondere ein Klebe- oder Hafteffekt der Verbindungsmasse erzeugt bzw. stabilisiert.

Die Verbindungsmasse kann durch ihre nachgiebige Konsistenz leichter und sicherer blasenfrei appliziert werden. Insbesondere können Luftspalte zwischen dem solaraktiven Element und dem transparenten Träger vermieden werden. Dies ist von Vorteil, wenn auch nicht unbedingt erforderlich. Die Verbindungsmasse kann insbesondere eine vollflächige und sehr dünne Kontaktschicht im Verbindungsbereich bilden. Dies kann für die Vermeidung von leistungsmindernden Spiegelungen oder Brechungen der einfallenden Lichtstrahlen von Vorteil sein.

Die Art und der Aufbau der weiteren Schichten kann variieren. Die Deckschicht kann z.B. die erwähnte flexible Folie sein. Alternativ kann es sich um eine stabilisierende Platte handeln, z.B. eine Glasplatte.

Die beanspruchte Fertigungstechnik ist auch für andere Arten von Solarmodulen einsetzbar, die z.B. mit wärmeabsorbierenden Lagen oder Körpern als solaraktives Element oder in Ergänzung zu einem solchen vorhanden sind. Auch aufgedampfte oder aufgedruckte solaraktive Elemente auf einem transparenten Träger können verarbeitet und mittels der Fertigungstechnik mit plattenförmigen Deckschichten mittels deren Wölbung und Einbringung einer Verbindungsmasse verbunden werden.

Nach einem weiteren Aspekt der Erfindung ist ein Verfahren zum Herstellen einer Schichtanordnung mit mehreren licht- oder solaraktiven Elementen für ein mehrschichtiges Modul, insbesondere Solarmodul, geschaffen, wobei das Verfahren die folgenden Schritte umfasst:
- Ausbilden einer Anordnung von lichtaktiven Elementen auf einer mit Saugöffnungen gebildeten Auflage, indem die lichtaktiven Elemente auf der Auflage abgelegt werden,
- Aufbringen einer flüssigen oder pastösen Verbindungsmasse auf die Anordnung von lichtaktiven Elementen und
- Ausbilden eines haftenden Schichtverbundes mit der Anordnung von lichtaktiven Elementen und einer plattenförmigen Schicht, wobei hierbei
- die plattenförmige Schicht mit Hilfe einer Wölbungseinrichtung mit einer Wölbung oder Krümmung auf die Anordnung von lichtaktiven Elementen aufgelegt wird,
- ein wenigstens in Zwischenräume zwischen den auf der Auflage abgelegten lichtaktiven Elemente hinein wirkender Saugdruck über die Saugöffnungen aufgegeben wird, und
- die lichtaktiven Elemente in die Verbindungsmasse blasenfrei eingebettet werden, derart, dass wenigstens ein Teil ihrer Außenfläche von der Verbindungsmasse bedeckt wird, indem die Wölbung der plattenförmigen Schicht auf der Anordnung von lichtaktiven Elementen mit der hierauf aufgebrachten Verbindungsmasse relaxiert und die Verbindungsmasse unter der Saugwirkung des Saugdrucks wenigstens in die Zwischenräume eingearbeitet wird.

Ein weiterer Aspekt der Erfindung sieht die Verwendung des Verfahrens zum Herstellen eines mehrschichtigen Moduls vor, insbesondere eines Solarmoduls mit Solarzellen.

Mit Hilfe des Verfahrens ist es ermöglicht, die licht- oder solaraktiven Elemente in die Verbindungs- oder Schichtmasse einzubetten, ohne dass es zum fehlerhaften Einschluss von Luftblasen kommt. Es werden allgemein Gaseinschlüsse in der Verbindungsmasse selbst und / oder in Bereichen vermieden, in denen die Verbindungsmasse und die Außenfläche der lichtaktiven Elemente oder die Verbindungsmasse und die Oberfläche der plattenförmigen Schicht aufeinanderstoßen. Der über die Saugöffnungen in den Zwischenbereichen zwischen den auf der Auflage abgelegten lichtaktiven Elementen entfaltete Saugwirkung bewirkt einerseits, dass dort befindliche Luft beim Einarbeiten der Verbindungsmasse abgesaugt wird. Aber auch beim Ausbilden der haftenden Schichtanordnung eventuell in der Verbindungsmasse auftretende Luftblasen werden (nachträglich) mittels der Saugwirkung in den Zwischenräumen abgesaugt.

Bei den lichtaktiven Elementen kann es sich um Solarzellen handeln, also Elemente, die Licht zum Erzeugen elektrischer Energie absorbieren. In einer anderen Ausgestaltung kann das Verfahren auch genutzt werden, um Licht emittierende Elemente, insbesondere in Form lichtemittierender Dioden, in die Schichtanordnung einzubetten.

Das Relaxieren der Wölbung oder Krümmung der plattenförmigen Schicht beim Ausbilden des haftenden Schichtverbundes bedeutet, dass die anfänglich lokal oder als ganzes gewölbte plattenförmige Schicht spätestens am Ende des Prozesses in die Form einer ebenen Platte übergeht, so dass die Anordnung lichtaktiver Elemente flächig bedeckt ist. Hierbei kann das Relaxieren ein einmaliger Prozess sein, beispielsweise dann, wenn am Anfang die plattenförmige Schicht als ganze gewölbt oder gekrümmt ist und dann bei der Ausbildung des Schichtverbundes relaxiert. Es kann aber auch vorgesehen sein, dass beim Relaxieren der Wölbung oder Krümmung zunächst nur in lokalen Bereichen der Platte eine Krümmung / Wölbung ausgebildet wird, die sich dann beim Abwälzen oder Abrollen über die Anordnung von lichtaktiven Elementen fortbewegt, so dass die Verbindungsmasse Stück für Stück eingearbeitet wird, was schließlich zur Einbettung der lichtaktiven Elemente führt. Die Krümmung / Wölbung der plattenförmigen Schicht kann in Abhängigkeit von dem herzustellenden Schichtverbund mit unterschiedlichen Radien ausgestaltet sein. Auch kann vorgesehen sein, dass ein Anfangsradius der Wölbung / Krümmung während des Relaxionsprozesses für lokale Bereiche der plattenförmigen Schicht unterschiedlich ist. Insgesamt wird ein gesteuertes Relaxieren der plattenförmigen Schicht ausgeführt, so dass diese am Ende im Wesentlichen eben ist.

Das Aufbringen der flüssigen oder pastösen Verbindungsmasse kann vor dem und / oder während des Anordnen(s) der plattenförmigen Schicht mit der Wölbung / Krümmung auf der Anordnung von lichtaktiven Elementen ausgeführt werden. Die Verbindungsmasse wird vorzugsweise mittels einer Dosiereinrichtung aufgebracht, bei der die Verbindungsmasse mit einem Düsenspender erfolgt, also einem Spender, bei dem die Ausbringbreite vernachlässigbar ist im Vergleich zur Ausbreitung der Anordnung von lichtaktiven Elementen. Auf diese Weise kann die Verbindungsmasse vor dem Aufsetzen der plattenförmigen Schicht linienförmig über die Anordnung von lichtaktiven Elementen verteilt werden. Die Auftragslinien können beliebige Linienformen aufweisen. Im Unterschied zum Stand der Technik, bei dem eine Schlitzdüse verwendet wird, die mit ihrer Schlitzbreite die Breite der Anordnung von lichtaktiven Elementen möglichst umfassend erfasst, ermöglicht das vorgeschlagene Verfahren eine anwendungsoptimierte Verteilung der aufgetragenen Verbindungsmasse, insbesondere derart, dass de Ausbildung und die Aufrechterhaltung einer stehenden Welle der Verbindungsmasse beim Relaxieren der plattenförmigen Schicht unterstützt wird.

Es hat sich in einer Ausführung als vorteilhaft erwiesen, auf die der Anordnung von lichtaktiven Elementen zugewandten Oberfläche der plattenförmigen Schicht Verbindungsmasse aufzutragen, bevor die plattenförmige Schicht aufgelegt wird. Auch dies kann mit der beschriebnen Dosiereinrichtung erfolgen.

Auch nach dem Anordnen der plattenförmigen Schicht mit der Wölbung / Krümmung auf der Anordnung von lichtaktiven Elementen kann das Aufbringen von Verbindungsmasse vorgesehen sein, beispielsweise auch dahingehend, dass weitere Verbindungsmasse zusätzlich zu schon aufgetragener Verbindungsmasse aufgebracht wird.

Das Ausbilden und das Relaxieren der Wölbung / Krümmung der plattenförmigen Schicht werden in einer Ausgestaltung dadurch unterstützt, dass die Schicht aus einem biegeelastischen Material besteht.

Beim Ausbilden des haftenden Schichtverbundes können weitere Verfahrensschritte vorgesehen sein, beispielsweise die Behandlung mit einer Heizeinrichtung, zum Beispiel zum Aushärten der Verbindungsmasse.

Die verwendete Auflage mit den Saugöffnungen verfügt über eine Anordnung von Saugöffnungen, die über die Arbeitsfläche der Auflage verteilt sind, nämlich den Bereich, in welchem die lichtaktiven Elemente aufgelegt werden. Die Ausgänge im Bereich der Arbeitsfläche können als Lochöffnungen ausgeführt sein. Es kann auch vorgesehen sein, dass eine Auflage verwendet wird, bei der sich Luftkanäle zur Arbeitsfläche der Auflage hin erweitern, insbesondere auch in Form von Oberflächenkanälen, die beispielsweise als Rinnen ausgeführt sind. Auf diese Weise wird das Ausbilden einer individuellen Druckverteilung über die Arbeitsfläche der Auflage während der Prozessschritte unterstützt. Es kann vorgesehen sein, dass mehrere Saugöffnungen im Bereich der Auflage im Material der Auflage über Kanäle miteinander verbunden sind. So kann die Auflage mit einer Kanalstruktur gebildet sein, die das Ausbilden unterschiedlicher Druckverhältnisse in lokal getrennten Bereichen der Auflage ermöglicht. Auch kann beispielsweise vorgesehen sein, die Saugwirkung an den zeitlichen Verlauf des Relaxierens der Wölbung / Krümmung anzupassen, beispielsweise derart, dass der Saugdruck für Saugöffnungen im Bereich einer momentanen Wölbung / Krümmung der plattenförmigen Schicht und / oder benachbart hierzu größer ist als in hierzu entfernten Bereichen der Auflage. Wenn sich der Krümmungs- / Wölbungsbereich oder der Relaxationsbereich der plattenförmigen Schicht dann über die Anordnung von lichtaktiven Elementen, also über die Auflage, fortbewegt, wird der Bereich erhöhten Saugdrucks mitbewegt, indem die Saugöffnungen entsprechend angesteuert werden. Steuerungstechnik zum anwendungsabhängigen Ansteuern der Saugöffnungen, individuell und / oder in Gruppen, ist als solche in verschiedenen Ausführungsformen bekannt.

Nachfolgend werden bevorzugte Ausgestaltungen des Verfahrens zum Herstellen einer Schichtanordnung mit mehreren lichtaktiven Elementen für ein mehrschichtiges Modul näher erläutert.

Eine bevorzugte Weiterbildung der Erfindung sieht vor, dass der Saugdruck in den Zwischenräumen mit Hilfe von Saugöffnungen erzeugt wird, die an der Auflage im Bereich der Zwischenräume und / oder unterhalb der abgelegten lichtaktiven Elemente angeordnet sind. Das Vorsehen von Saugöffnungen unterhalb der abgelegten lichtaktiven Elemente hat den Vorteil, dass diese Saugöffnungen zusätzlich für eine flächige Auflage der lichtaktiven Elemente auf der Auflage sorgen können, beispielsweise wenn die lichtaktiven Elemente zuvor verbogen waren. Auch eine Lagefixierung der abgelegten Elemente wird so erreicht. Sollte die Anordnung von Saugöffnungen ausschließlich Saugöffnungen unterhalb der abgelegten lichtaktiven Elemente aufweisen, so ist dafür zu sorgen, dass die Saugwirkung sich auch in die Zwischenbereiche zwischen den abgelegten lichtaktiven Elementen erstreckt. Dies wird beispielsweise dadurch erreicht, dass die Arbeitsfläche der Auflage, auf der die lichtaktiven Elmente abgelegt sind, mit einer Rauhigkeit gebildet ist, die das Ausbilden der Sogwirkung in den Zwischenräumen oder -bereichen erlaubt.

Bei einer zweckmäßigen Ausgestaltung der Erfindung kann vorgesehen sein, dass die Verbindungsmasse aufgrund des Saugdrucks wenigstens in umlaufenden Randbereichen der lichtaktiven Elemente bis in einen Bereich blasenfrei gelangt, in welchem die Oberfläche der Auflage und ein zugeordnete Oberfläche der lichtaktiven Elemente sich einander gegenüberliegen. Auf diese Weise wird zum Bespiel dafür gesorgt, dass Kantenbereiche der lichtaktiven Elemente auf der der Auflage zugewandten Seite der lichtaktiven Elemente teilweise oder vollständig in die Verbindungsmasse eingebettet werden.

Eine vorteilhafte Ausführungsform der Erfindung sieht vor, dass eine oder mehrere der Saugöffnungen nach dem Ausbilden des haftenden Schichtverbundes mit einem Überdruck beaufschlagt werden, um ein Lösen des haftenden Schichtverbundes von der Auflage zu unterstützen.

Bevorzugt sieht eine Fortbildung der Erfindung vor, dass die Saugöffnungen einzeln und / oder in Gruppen hinsichtlich eines zugeordneten Saug- / Überdrucks angesteuert werden, um lokal unterschiedliche Druckverhältnisse einzustellen. So können lokale Bereiche der Auflage hinsichtlich der Druckverhältnisse individuell eingerichtet werden, insbesondere für unterschiedliche Prozessabschnitte.

Bei einer vorteilhaften Ausgestaltung der Erfindung kann vorgesehen sein, dass beim Ausbilden der Anordnung von lichtaktiven Elementen auf der Auflage frontseitig und / oder rückseitig kontaktierte lichtaktiven Elemente abgelegt werden, wobei im Fall der frontseitig kontaktierten lichtaktiven Elemente Kontaktleitungen beim Ablegen der Solarzelle in oberflächigen Vertiefungen auf der Auflage angeordnet werden. Im Fall von Solarzellen erfolgt eine frontseitige Kontaktierung zum Beispiel mittels so genannter Kontaktfäden.

Bei einer vorteilhaften Ausgestaltung der Erfindung kann vorgesehen sein, dass beim Relaxieren der Wölbung oder Krümmung der plattenförmigen Schicht in einem Zwickel zwischen der Anordnung von lichtaktiven Elementen auf der Auflage und der der Anordnung von lichtaktiven Elementen zugewandten Oberfläche der plattenförmigen Schicht eine über die Anordnung von lichtaktiven Elementen laufende stehende Welle der Verbindungsmasse erzeugt wird. Die stehende Welle der Verbindungsmasse kann auch als eine Art über die Anordnung von lichtaktiven Elementen laufende Wulst betrachtet werden. Dieses unterstützt in vorteilhafter Weise die Vermeidung des Einschlusses von Luft in die Verbindungsmasse. Hierbei hat es sich als vorteilhaft erwiesen, eine Menge an Verbindungsmasse auf die plattenförmige schicht aufzutragen, bevor diese auf die Anordnung von lichtaktiven Elementen aufgelegt wird. Hierdurch wird insbesondere die anfängliche Ausbildung der Welle am Beginn des relaxierenden Auflegens der plattenförmigen Schicht unterstützt.

Eine bevorzugte Weiterbildung der Erfindung sieht vor, dass beim Relaxieren der Wölbung oder Krümmung der plattenförmigen Schicht mittels einer Dosiereinrichtung Verbindungsmasse, wahlweise auch ergänzend zu vorher aufgebrachter Verbindungsmasse, im Zwickel zwischen der Anordnung von lichtaktiven Elementen auf der Auflage und der der Anordnung von lichtaktiven Elementen zugewandten Oberfläche der plattenförmigen Schicht Verbindungsmasse eingebracht wird. Insbesondere kann das Eindosieren der Verbindungsmasse in den Zwickel zur Ausbildung und / oder Aufrechterhaltung der stehenden Welle beim Relaxieren der Wölbung oder Krümmung verwendet werden.

Bei einer zweckmäßigen Ausgestaltung der Erfindung kann vorgesehen sein, dass beim Ausbilden des haftenden Schichtverbundes die plattenförmige Schicht mittels einer Andrückvorrichtung angedrückt wird.

Eine vorteilhafte Ausführungsform der Erfindung sieht vor, dass als plattenförmige Schicht eine Platte aus einem lichtdurchlässigen Material verwendet wird. Bei dem lichtdurchlässigen Material kann es sich beispielsweise um Glas oder Kunststoff handeln. Auch kann das beschriebene Verfahren eingesetzt werden, eine Folienschicht in dem haftenden Schichtverbund auszubilden. Mit Hilfe der plattenförmigen Schicht kann eine vorderseitige oder eine rückseitige Deckschicht hergestellt werden. Aber auch das Ausbilden einer Zwischenschicht für den Schichtverbund kann vorgesehen sein, was insbesondere dann der Fall ist, wenn sich weitere Verfahrensschritte zum Ausbilden von Schichten anschließen. Das beschriebene Verfahren kann beim Herstellen einer Anordnung von lichtaktiven Elementen auch mehrfach zum Einsatz kommen, um mehrere Schichten mit Hilfe von plattenförmigen Schichten herzustellen.

Bevorzugt sieht eine Fortbildung der Erfindung vor, dass die plattenförmige Schicht mit einer lokalen, nicht die gesamte plattenförmige Schicht erfassenden Wölbung oder Krümmung auf die Anordnung von lichtaktiven Elementen aufgelegt wird, wobei die lokale Wölbung oder Krümmung beim Relaxieren der plattenförmigen Schicht über die Anordnung von lichtaktiven Elementen läuft, wahlweise mit sich veränderndem Wölbungs- / Krümmungsradius. Auch kann in einer Ausgestaltung vorgesehen sein, dass eine Anfangswölbung nach zwei Seiten gleichzeitig in gleicher oder unterschiedlicher Form relaxiert. In dieser oder anderen Ausgestaltungen bedeutet das Auflegen der plattenförmigen Schicht mit der Wölbung oder Krümmung auf die Anordnung von lichtaktiven Elementen bevorzugt nicht einen direkten Berührungskontakt zwischen der plattenförmigen Schicht und den lichtaktiven Elementen, sondern vielmehr ein Aufsetzen der plattenförmigen Schicht auf einen Teil der aufgebrachten Verbindungsmasse. Auch wenn in Einzelfällen, wenn dieses prozesstechnisch vorteilhaft ist, ein direkter Kontakt zwischen der plattenförmigen Schicht und der Anordnung von lichtaktiven Elementen in Zwischenschritten des Herstellungsprozesses nicht ausgeschlossen ist. Der hergestellte Schichtverbund ist jedoch regelmäßig dadurch charakterisiert, dass zwischen der der plattenförmigen Schicht zugewandten Oberfläche der lichtaktiven Elemente und der der Anordnung lichtaktiver Elemente zugeordneten Oberfläche der plattenförmigen Schicht Verbindungsmasse flächig angeordnet ist.

Bei einer vorteilhaften Ausgestaltung der Erfindung kann vorgesehen sein, dass als flüssige oder pastöse Verbindungsmasse eine siliconbasierte Verbindungsmasse verwendet wird.

Bei einer vorteilhaften Ausgestaltung der Erfindung kann vorgesehen sein, dass die plattenförmige Schicht beim Ausbilden der Wölbung oder Krümmung und deren Relaxieren mit einem randseitigen Niederhalter und mit einem höhenverstellbaren Drückelement gebogen wird.

Eine bevorzugte Weiterbildung der Erfindung sieht vor, dass beim Ausbilden des haftenden Schichtverbundes ein Vorschub eines Andrückelements entlang der plattenförmigen Schicht und eine Einfahrbewegung eines Drückelements zum gesteuerten Relaxieren der Wölbung oder Krümmung aufeinander abgestimmt eingestellt werden.

Bevorzugt kann das beschriebene Verfahren in einer Ausgestaltungen in einem Prozess der Herstellung eines mehrschichtigen Moduls mit mehreren lichtaktiven Elementen verwendet werden, insbesondere zum Herstellen eines mehrschichtigen Solarmoduls, bei dem die lichtaktiven Elemente als Solarzellen ausgeführt sind. Das Verfahren zum Herstellen der Schichtanordnung mit lichtaktiven Elementen ist dann integriert in einen Gesamtherstellungsprozess zum Ausbilden von mehrschichtigen Modulen. Hierbei ergänzend verwendete Verfahrensschritte sind als solche in verschiedenen Ausführungsformen bekannt. In Verbindung mit Solarmodulen umfasst der Herstellungsprozess dann in einer Ausgestaltung das Ausbilden sowohl einer vorderseitigen als auch einer rückseitigen Deckschicht. Für das Herstellen einer oder beider Deckschichten kann der vorgenannt beschriebene Prozess eingesetzt werden. Auf der Vorderseite kann die Deckschicht beispielsweise mit Hilfe einer Glas- oder Kunststoffplatte hergestellt werden. Für die rückseitige Deckschicht kann zum Beispiel ein Folienmaterial zum Einsatz kommen.

In den Unteransprüchen sind weitere vorteilhafte Ausgestaltungen der Erfindung angegeben.

Die Erfindung ist in den Zeichnungen beispielhaft und schematisch dargstellt. Im Einzelnen zeigen:
- Figur 1:: in einer perspektivischen Ansicht eine zellenartige Fertigungseinrichtung für ein Solarmodul,
- Figur 2:: eine schematische Draufsicht auf ein Solarmodul,
- Figur 3 und 4:: einen Längsschnitt durch ein Solarmodul in verschiedenen Aufbaustufen,
- Figur 5 bis 8:: Seitenansichten der Fertigungseinrichtung in verschiedenen Prozessstufen,
- Figur 9:: einen alternativen Aufbau von Teilen eines Solarmoduls im Längsschnitt
- Figur 10:: eine ausschnittsweise Darstellung des Wölb- und Wälzeffekts beim Anpressen benachbarter Schichten und Verteilung einer Verbindungsmasse,
- Figur 11 bis 13:: Varianten der Fertigungseinrichtung mit einer Aufbringvorrichtung für rückseitige Schichten des Solarmoduls,
- Figur 14:: eine vergrößerte perspektivische Darstellung der Auflage und der Wölbungseinrichtung der Fertigungseinrichtung von Figur 1,
- Figur 15:: eine Seitenansicht der Fertigungseinrichtung von Figur 1 in Verbindung mit einem anderen Schichtenaufbau,
- Figur 16 und 17:: eine Draufsicht und eine Seitenansicht einer Auftragvorrichtung und eines Andrückelements,
- Figur 18:: eine perspektivische Draufsicht auf eine Auflage der Fertigungseinrichtung und
- Figur 19:: eine schematische Darstellung des Aufwälzvorgangs an einer Auflage gemäß Figur 18 und einer Vorrichtung zum Herstellen einer Schichtanordnung mit lichtaktiven Elementen, insbesondere eine Solarzellenanordnung.

Die Erfindung betrifft eine Technologie in Verbindung mit mehrschichtigen Modulen mit lichtaktiven Elementen, insbesondere mehrschichtigen Solarmodulen (1). Die Erfindung betrifft ein mehrschichtiges Solarmodul (1), eine mehrschichtige Basiskomponente (1') und eine Fertigungseinrichtung (2) sowie ein Fertigungsverfahren zur Herstellung eines Schicht- oder Solarmoduls (1).

Das Solarmodul (1) kann unterschiedlich aufgebaut sein und unterschiedliche Funktionen zur Umwandlung von Sonnenenergie oder anderer Lichtenergie bzw. Strahlungsenergie haben. Es kann sich insbesondere um ein Fotovoltaikmodul zur Stromerzeugung handeln. Es kann alternativ ein Hybridmodul sein, welches zusätzlich die bei der Strahlungsumwandlung entstehende Wärme aufnimmt und nutzt. Schließlich kann es sich auch um ein Kollektormodul zur Wärmeerzeugung handeln. Das Solarmodul (1) kann eine ebene und plattenförmige Gestalt haben. Es kann alternativ eine andere Formgebung haben, insbesondere eine gewölbte Form.

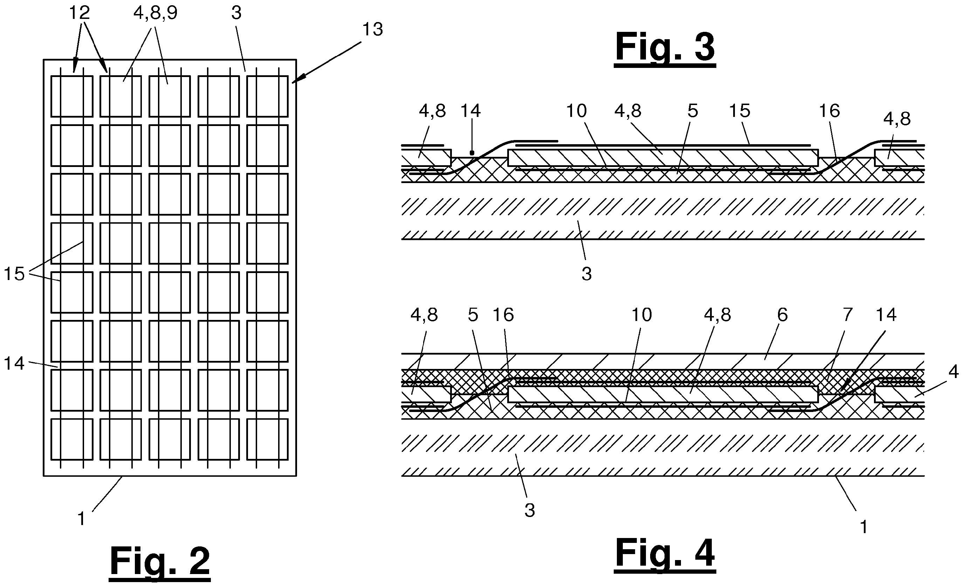

Das Solarmodul (1) weist zur Aufnahme und Umwandlung der einfallenden Sonnen- oder Strahlungsenergie ein solaraktives Element (4) auf, welches auch mehrfach vorhanden sein kann und eine Schicht innerhalb des Solarmoduls (1) bildet. Das solaraktive Element (4) kann in unterschiedlicher Weise ausgebildet sein. Es kann sich z.B. gemäß Figur 3 und 4 um eine Solarzelle (8) handeln, die ein lichtreaktives Teil (10) in Form eines kristallinen Körpers aus Silizium oder dgl. mit einseitig oder beidseits angebrachten elektrischen Leitungen (15) aufweist. In einer anderen Ausführungsform kann das solaraktive Element (4) eine Hybridanordnung (9) sein, die zum einen das vorgenannte lichtreaktive Teil (10) mit den Leitungen (15) an der Lichteinfallseite und zum anderen ein rückseitiges, mehrere solaraktive Element (4) überdeckendes Thermoteil (11) aufweist. Dies kann z.B. eine wärmeabsorbierende Schicht sein, welche die im oder am lichtreaktiven Teil (10) entstehende Wärme aufnimmt und ggf. abführt. Dies kann durch Wärmeleitung, durch Wärmetausch mit einem umgewälzten fluidischen Medium oder auf andere Weise geschehen.

Das Solarmodul (1) weist i.d.R. mehrere miteinander in einer Schicht bzw. einer Ebene nebeneinander angeordnete solaraktive Elemente (4) auf. Diese können z.B. in einer einzelnen Reihe bzw. einem sog. String (12) hintereinander und mit gegenseitigem Abstand oder Spalt (14) angeordnet sein. Mehrere Strings (12) können miteinander eine flächige Matrix (13) bilden, wobei wiederum seitliche Abstände oder Spalte (14) vorhanden sind. Innerhalb eines Strings (12) sind die solaraktiven Elemente (4) mit ihren elektrischen Leitungen (15) in Reihe hintereinander geschaltet, wobei die Verbindung durch geeignete Leitungsstücke, sog. Bändchen (16), geschaffen wird, die in geeigneter Weise mit den Leitungen (15) verbunden werden, z.B. durch Löten. Figur 3, 4 und 9 zeigen hierfür unterschiedliche Ausführungsvarianten in einem abgebrochenen und vergrößerten Längsschnitt. Die Strings (12) und deren Leitungen (15) sind am Ende untereinander elektrisch querverbunden und an eine von außen zugängliche Kontaktstelle angeschlossen. Figur 2 zeigt diese Ausbildung des Solarmoduls (1) in einer schematischen Darstellung.

Das Solarmodul (1) weist mehrere übereinander liegende Schichten (3,4,5,6,7) auf, die miteinander verbunden sind. Der Schichtaufbau ist z.B. in Figur 4 schematisch dargestellt. An der Lichteinfallseite des Solarmoduls (1) ist ein transparenter und lichtdurchlässiger Träger als erste Schicht (3) angeordnet. Der Träger (3) kann eine Plattenform haben und eine die Formgebung des gesamten Solarmoduls (1) bestimmende und stabilisierende Festigkeit haben. Er kann hierfür eine entsprechende Dicke haben. Alternativ kann die Dicke und Tragkraft geringer sein, wobei andere Schicht(en) (6) mittragen. Der Träger (3) kann z.B. aus Glas, Kunststoff, insbesondere Polycarbonat oder dgl. oder einem anderen geeigneten lichtdurchlässigen Material bestehen.

Auf dem Träger (3) liegt die von ein oder mehreren solaraktiven Elementen gebildete nächste Schicht (4). Zwischen diesen Schichten (3,4) befindet sich eine Verbindungsmasse (5), die aus einem lichtdurchlässigen Material besteht und die einen dünnen Film zwischen den parallelen Oberflächen der Schichten (3,4) bildet. Die Verbindungsmasse (5) sorgt für eine Verklebung oder eine sonstige haftende Verbindung zwischen den Schichten (3,4) und hat vollflächigen Kontakt mit den besagten Schichten (3,4). Die Verbindungsmasse (5), die ebenfalls eine Schicht im Schichtaufbau des Solarmoduls (1) bildet, füllt auch die Abstände oder Spalte (14) zwischen den einzelnen solaraktiven Elementen (4) zumindest teilweise aus. Sie kann die Spalte (14) vollständig ausfüllen und bis zur rückwärtigen Oberseite der solaraktiven Elemente (4) reichen.

Die solaraktiven Elemente (4) sind in die Verbindungsmasse (5) eingebettet und werden von dieser an der lichtaktiven Seite bzw. Oberfläche und an den umlaufenden Rändern mit dichtem Anschluss umgeben.

Die Verbindungsmasse (5) ist anfangs nachgiebig und erlaubt ein Einbetten der solaraktiven Elemente (4). Die Verbindungsmasse (5) kann anschließend verfestigen, was auf unterschiedliche Weise möglich ist. Dies kann z.B. ein Erstarren durch Aushärten sein. Das Aushärten kann warm oder kalt, durch Licht- oder Strahlungseinfall oder auf andere Weise erfolgen. Die Verbindungsmasse (5) hat im Anfangszustand bei der Herstellung des Solarmoduls (1) eine pastöse oder flüssige Konsistenz. Diese fließfähige Eigenschaft ermöglicht ein Ausweichen und gleichmäßiges Verteilen der Verbindungsmasse (5) sowie ein Ausfüllen der Spalte (14) zur Einbettung des oder der solaraktiven Elemente (4).

Die Verbindungsmasse (5) kann in unterschiedlicher Weise ausgestaltet sein. Sie kann aus einer, zwei, drei oder mehr Komponenten bestehen. Bei zwei, drei oder mehr Komponenten können diese bei der Mischung miteinander reagieren und zu einer Aushärtung oder anderweitigen Verfestigung der Verbindungsmasse (5) führen. In einer nicht dargestellten Abwandlung kann die Verbindungsmasse (5) auch in Form einer Bahn oder Folie vorliegen und eine kompressible Konsistenz haben, welche das besagte Einbetten unter Materialverdrängung erlaubt. Die Verbindungsmasse (5) kann klebende Eigenschaften haben. Sie kann insbesondere Silikon oder silikonhaltige Verbindungen aufweisen. Silikon hat den Vorteil der Lichtdurchlässigkeit und der Alterungsbeständigkeit.

Der Träger (3) mit der Verbindungsmasse (5) und der oder den eingebetteten solaraktiven Elementen (4) kann eine Basiskomponente (1') des Solarmoduls (1) darstellen, die bei unterschiedlichen Modultypen gleichermaßen vorhanden ist. Der weitere Schichtaufbau und die ggf. daraus resultierende Funktion des Solarmoduls (1) kann variieren. Das Solarmodul (1) kann insbesondere eine rückseitige äußere Deckschicht (6) aufweisen, die lichtdurchlässig oder lichtdicht sein kann. Die Deckschicht (6) kann z.B. aus einer biegeelastischen dünnen Bahn, insbesondere einer Folie, bestehen. Sie kann alternativ eine Plattenform haben und kann z.B. aus einer lichtdurchlässigen Glas- oder Kunststoffplatte bestehen.

Zwischen der Deckschicht (6) und der Basiskomponente (1'), insbesondere der Rückseite der Schicht (4) mit den ein oder mehreren solaraktiven Elementen, kann eine Verbindungsschicht (7) angeordnet sein. Diese kann z.B. ebenfalls aus einer fließfähigen Masse bestehen und kann z.B. ein Kunststoff sein. Alternativ kann hier auch eine EVA-Folie oder sonstige Klebe- oder Verbindungsfolie angeordnet sein. Die Verbindungsschicht (7) kann insbesondere aus dem gleichen Material wie die Verbindungsmasse (5) bestehen und mit dieser zusammen für einen dichten, insbesondere auch luftdichten, allseitigen Umschluss und Verbund des oder solaraktiven Elemente (4) sorgen.

In der gezeigten Ausführungsform besteht das Solarmodul (1) aus fünf übereinander liegenden Schichten (3,4,5,6,7). Die Schichtenzahl kann hiervon abweichen und kann insbesondere größer sein. Sie kann auch kleiner sein, wobei z.B. die mit Überschuss vorhandene Verbindungsmasse (5) durch die Spalte (14) gedrückt wird und die Rückseite der solaraktiven Schicht (4) zumindest stellenweise bedeckt. Die Verbindungsschicht (7) kann dadurch entfallen.

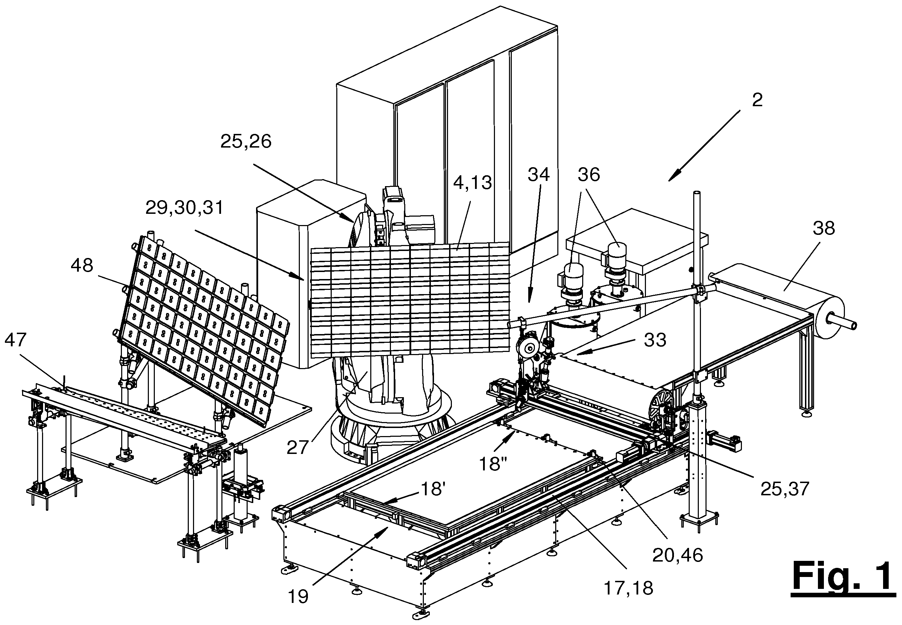

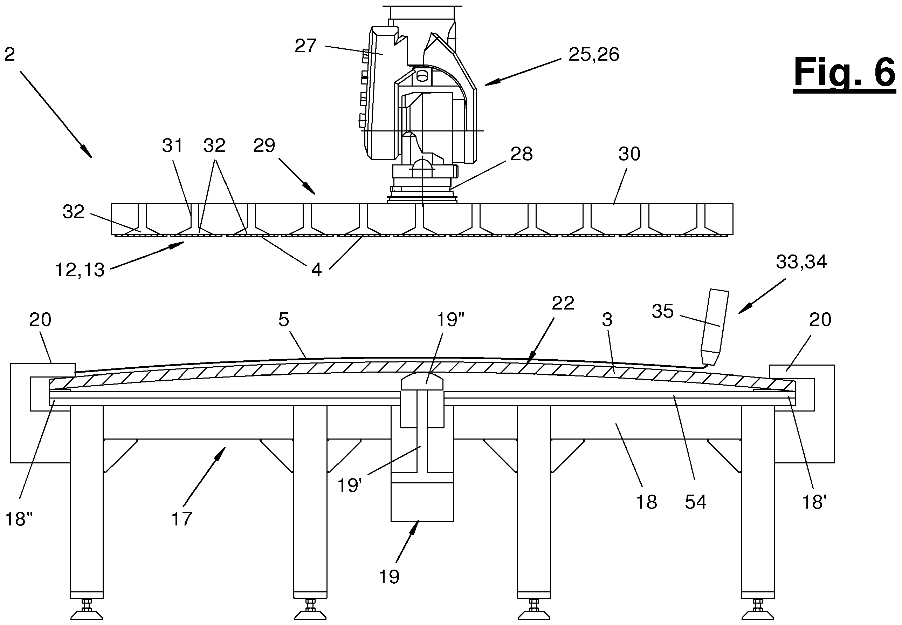

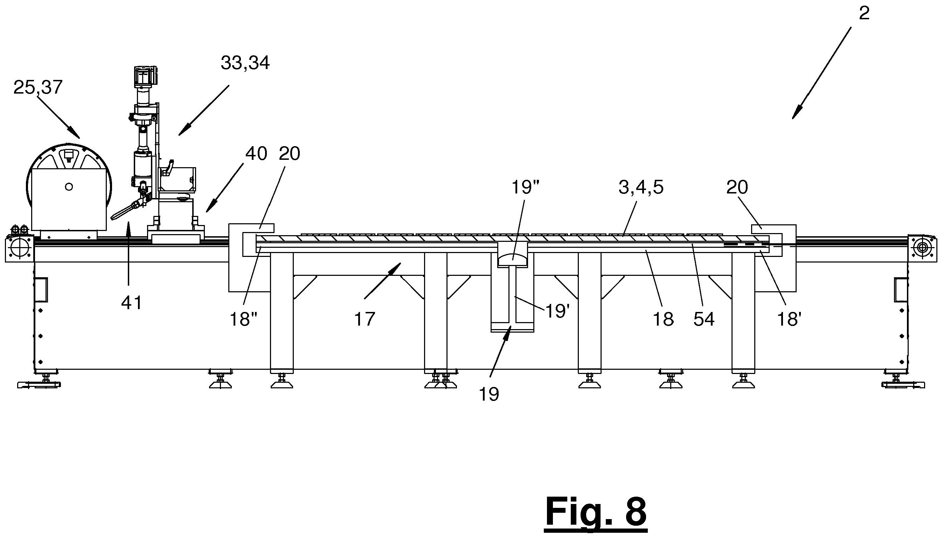

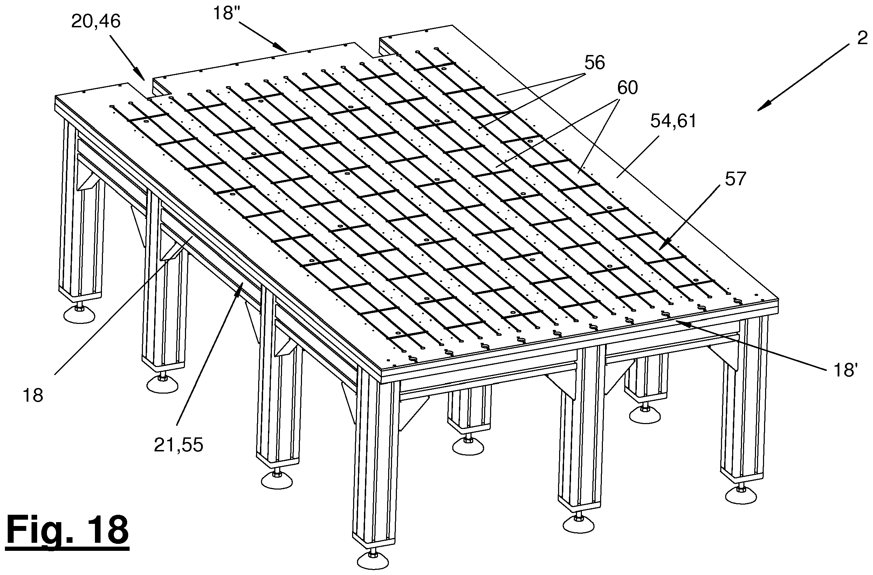

Figur 1 und 5 bis 8 sowie 11 bis 13 und 14 bis 18 zeigen eine Fertigungseinrichtung (2) für das vorbeschriebene Solarmodul (1) in verschiedenen Varianten. Die Fertigungseinrichtung (2) kann auch für andere Ausführungsformen von Solarmodulen (1) eingesetzt werden.

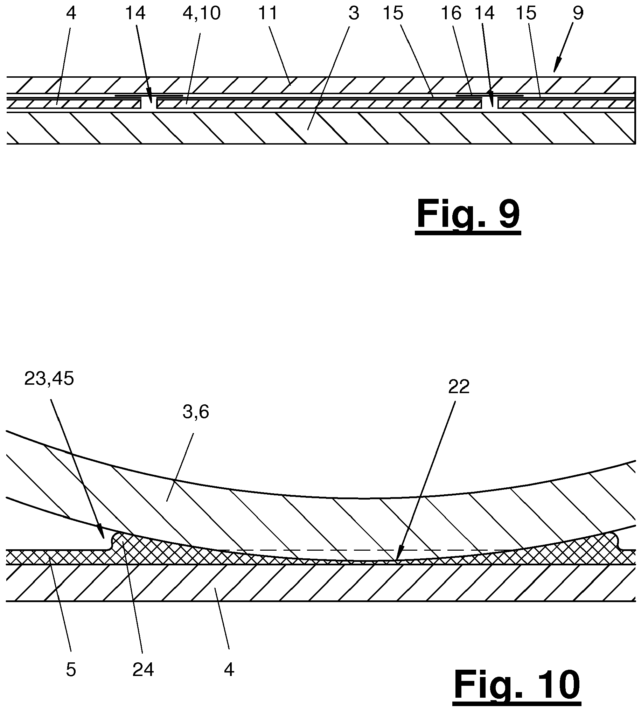

Die Fertigungseinrichtung (2) weist eine Einrichtung zur Bildung des mehrschichtigen Aufbaus eines Solarmoduls (1) und eine Einrichtung zum Auftragen und gleichmäßigen Verteilen einer Verbindungsmasse (5) auf. Die Verteilung wird mechanisch unterstützt durch die Ausbildung einer Wölbung (22) an mindestens einer der an der Verbindung beteiligten Schichten (3,4,6). Die Wölbung (22) ist reversibel bzw. relaxierbar und hat eine zum Verbindungsbereich hin gerichtete konvexe Form. Wie Figur 10 verdeutlicht, werden z.B. die Schichten (3,4) mit der dazwischenliegenden Verbindungsmasse (5) zusammengedrückt, wobei die Wölbung (22) der einen Schicht (3) dann nach und nach aufgehoben oder relaxiert wird und parallel zur Lage und Ausrichtung der anderen an der Verbindung beteiligten Schicht (4) ausgerichtet wird. Die andere Schicht (4) hat in der gezeigten Ausführungsform eine ebene und in geeigneter Weise stabilisierte Lage. Durch die Wölbungsrelaxation wird auch die andere Schicht (3) nach und nach in eine Planlage gebracht.

Die Wölbung (22) ist z.B. mittig an der Schicht (3,6) angeordnet und ist nur einmal vorhanden. Sie kann auch mehrfach vorhanden sein. Beim Zusammenpressen der Schichten (3,4) findet zunächst eine Schichtenannäherung im Scheitelbereich der Wölbung (22) statt, wobei hier die Verbindungsmasse (5) komprimiert oder quer zur Krümmungsachse verdrängt wird. In dem hierbei von der Wölbung (22) gebildeten Zwickel (23,45) formt sich ein Wulst (24) der Verbindungsmasse (5) aus, der mit zunehmender Relaxation seitlich und zum Modulrand fortschreitet. Durch die Wölbungsrelaxation findet eine Massenverdrängung und eine gleichzeitig gleichmäßige Verteilung der Verbindungsmasse (5) statt, die durch ihr Fließverhalten auch etwaige Leerstellen ausfüllt und verschließt. Zudem kann die Verbindungsmasse (5) in die Spalte (14) eindringen und diese zumindest teilweise ausfüllen. Durch die Wölbungsrelaxation findet auch ein Aufwälzvorgang statt, durch den Luft- oder andere Gaspolster verdrängt und aus dem Verbindungsbereich zwischen den Schichten (3,4) entfernt werden. Am Ende ergibt sich eine dünne filmartige und geschlossene Lage oder Schicht der Verbindungsmasse (5) zwischen den angrenzenden Schichten (3,4), insbesondere dem Träger (3) und dem oder den solaraktiven Elementen (4). Eine nicht dargestellte stationäre oder mitbewegte Seitenbegrenzung kann einen ggf. unerwünschten seitlichen Austritt der Verbindungsmasse (5) aus dem Zwickelbereich bei der Wölbungsrelaxation vermeiden.

Diese Aufwälz- und Verteilungstechnik mit einer relaxierbaren Wölbung (22) lässt sich auch für andere Arten von Solarmodulen (1) und andere Schichten einsetzen. In den gezeigten Ausführungsformen wird die plattenförmige Schicht bzw. der Träger (3) gebogen und gewölbt, wobei die Schicht (4) der solaraktiven Elemente eine Planlage einnimmt. In einer anderen nicht dargestellten Ausführungsform kann die Wölbung (22) an der Schicht (4) und den solaraktiven Elementen vorgesehen sein, wobei die Schicht (3) bzw. der lichtdurchlässige Träger eine Planlage einnimmt. In weiterer Abwandlung können beide Schichten (3,4) einander zugekehrte konvexe Wölbungen (22) haben, die in gegenseitiger Abstimmung relaxiert werden. Ferner kann z.B. in einer nicht dargestellten Modulvariante am lichtdurchlässigen Träger (3) ein einzelnes oder mehrere solaraktive Elemente (4) angebracht, insbesondere aufgedampft sein, wobei die vorbeschriebene Fertigungs- und Verbindungstechnik dazu benutzt wird, um diese Grundkomponente mit einer rückseitigen Deckschicht über eine dazwischen aufgetragene Verbindungsmasse (5) zu verbinden. Hierbei kann z.B. die ebenfalls plattenförmige Deckschicht (6) gewölbt und an den planen Träger (3) angepresst und angewalzt werden. In weiterer Abwandlung können auch beide Träger- und Deckschichten gewölbt und in einem Abwälz- und Massenverteilungsvorgang relaxiert werden. Außerdem kann die Wölbung (22) eine andere Form und Ausrichtung haben, die nicht mittensymmetrisch sein muss.

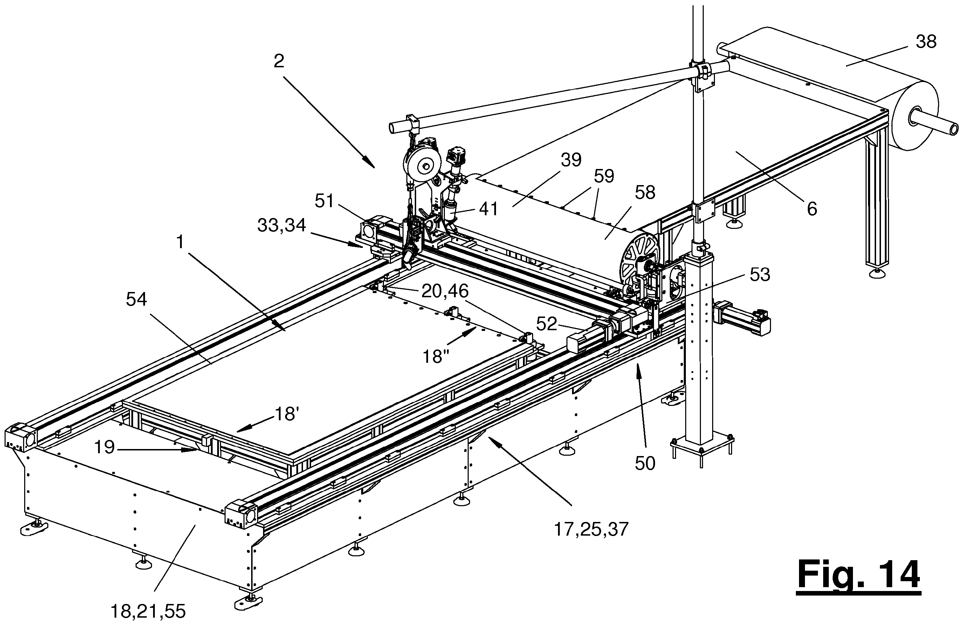

Figur 1 und 14 zeigen eine Fertigungseinrichtung (2) in Form einer Fertigungszelle. In einer nicht dargestellten Variante kann die gezeigte Zelle zu einer Durchlaufanlage mit mehreren hintereinander angeordneten Stationen abgewandelt werden.

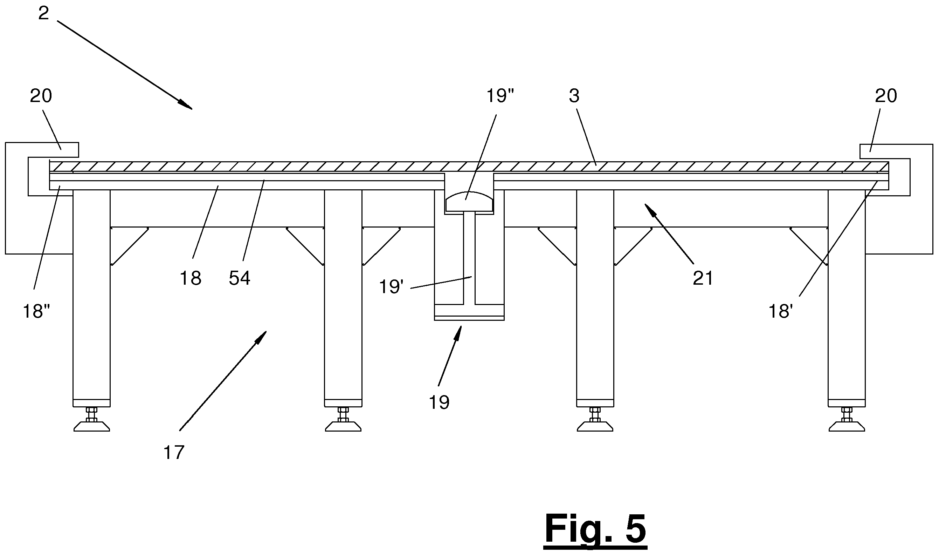

Die Fertigungseinrichtung (2) weist eine steuerbare Wölbungseinrichtung (17) für eine Schicht (3,4,6) auf. Die Wölbungseinrichtung (17) kann in beliebig geeigneter Weise mindestens eine vorerwähnte Wölbung (22) bilden. Dies kann insbesondere durch Biegen einer plattenförmigen Schicht (3,6) geschehen, wobei die Wölbungseinrichtung (17) als Biegeeinrichtung ausgebildet ist. Die Wölbungseinrichtung (17) erzeugt die vorbeschriebene veränderliche und relaxierbare Wölbung (22) oder Krümmung einer Schicht (3,4,6). In Figur 5 bis 7 ist die Wölbungseinrichtung (17) und deren Funktion näher dargestellt.

Die Fertigungseinrichtung (2) weist ferner eine Auftragvorrichtung (33) für eine Verbindungsmasse (5,7) auf. Zudem ist eine Andrückvorrichtung (25) vorgesehen, mit der die zu verbindenden Schichten (3,4,6) mit der dazwischenliegenden Verbindungsmasse (5,7) zusammengedrückt werden.

Die Auftragvorrichtung (33) und die Andrückvorrichtung (25) können in verschiedener Weise ausgebildet sein. In der gezeigten Ausführungsform von Figur 5 bis 8 ist die Andrückvorrichtung (25) mit einer Handhabungseinrichtung (26) kombiniert, welche außerdem Zuführungs- und Handhabungsaufgaben zur Bildung des Schichtaufbaus erfüllt. Bei den anderen Varianten kann sie von einem Andrückelement (39) gebildet werden.

Die Handhabungseinrichtung (26) kann z.B. einen Manipulator (27) aufweisen, der eine oder mehrere Bewegungsachsen hat. Vorzugsweise hat der Manipulator (27) zwei oder mehr rotatorische und/oder translatorische Bewegungsachsen in geeigneter Konfiguration und hat einen räumlichen Arbeitsbereich. In der gezeigten Ausführungsform kommt ein Gelenkarmroboter mit sechs rotatorischen Achsen zum Einsatz, der stationär oder auf ein oder mehreren Zusatzachsen beweglich angeordnet sein kann. Der Industrieroboter (27) besitzt eine Hand (28) mit mindestens einer Bewegungsachse, vorzugsweise zwei oder drei rotatorischen Bewegungsachsen. An der Hand (28) ist eine Trageinrichtung (29) fest oder lösbar, ggf. unter Zwischenschaltung einer Wechselkupplung, angeordnet. Die Trageinrichtung (29) kann auch bedarfsweise gewechselt werden.

Im Arbeitsbereich der Handhabungseinrichtung (26) können sich Zuführungen für Modulteile, insbesondere für plattenartige Träger (3) und solaraktive Elemente (4) befinden, die von der Einrichtung (26) zum Schichtenaufbau gehandhabt werden. Die Fertigungseinrichtung (2) kann beispielsweise eine Stringablage (47) haben, auf der von einer externen Produktionsstelle Strings (12) zugeführt werden. Die Handhabungseinrichtung (26) kann mit der Trageinrichtung (29) die Strings (12) aufnehmen und zu einer Matrixablage (48) bringen, an der die Matrix (13) aus mehreren Strings (12) nach und nach aufgebaut wird.

Die Matrixbildung kann auch auf andere Weise und durch andere Einrichtungen erfolgen. Die Handhabungseinrichtung (26) nimmt mit der Trageinrichtung (29) die Matrix (13) auf und legt sie auf die zuvor an der Wölbungseinrichtung (17) positionierte Schicht (3), insbesondere in Form eines plattenartigen Trägers (3). Die Zuführung der Schicht (3) kann ebenfalls durch die Handhabungseinrichtung (26) in einem vorhergehenden oder nachfolgenden Prozessschritt bewirkt werden.

Die Trageinrichtung (29) weist z.B. eine Tragplatte (30) mit einer ebenen funktionalen Oberfläche auf, die aus einem für die Verbindungsmasse (5) inerten Material, z.B. Teflon oder dgl., besteht. An der Tragplatte (30) sind mehrere Greifelemente (31) angeordnet, welche auf die Handhabung der jeweiligen Schichten (3,4,6) und ihrer Teile adaptiert sind.

Im gezeigten Ausführungsbeispiel von Figur 5 bis 8 sind die Greifelemente (31) als Sauger ausgebildet, die jeweils an der frontseitigen Oberfläche eine Saugöffnung (32) aufweisen. Die Saugöffnungen (32) können in gleicher Zahl und Verteilung wie die solaraktiven Elemente (4) im String (12) bzw. in der Matrix (13) vorhanden und angeordnet sein und greifen diese Elemente (4) vorzugsweise mittig. Pro Element (4) können ein oder mehrere Saugöffnungen (32) vorhanden sein. Die Sauger (31) können schaltbar und ggf. auch in ihrer Saugleistung und Haltekraft steuerbar sein. Die Spalte (14) werden durch die rückseitige Tragplatte (30) überbrückt, wobei hier ggf. vertiefte Nuten und/oder andere Öffnungen in der Plattenoberfläche zur Aufnahme etwaiger Überschüsse der Verbindungsmasse (5) angeordnet sein können.

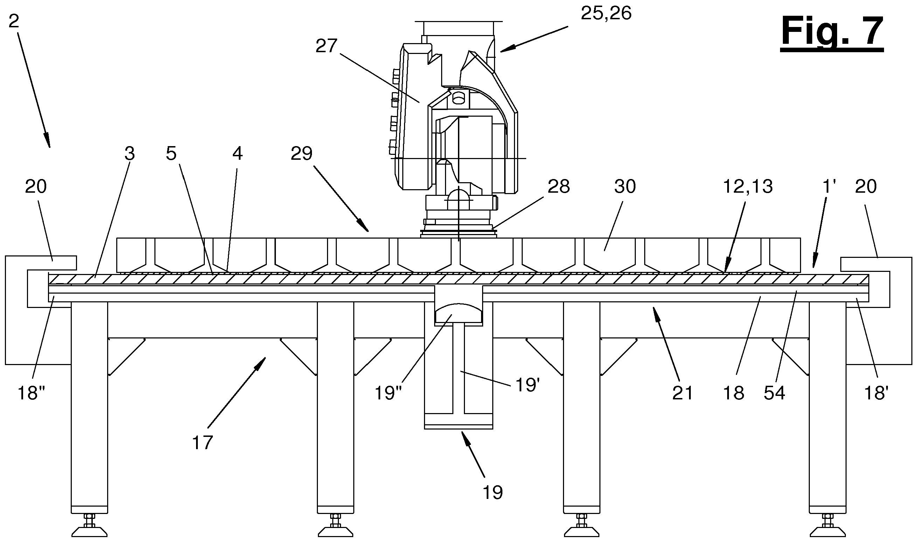

Die Wölbungseinrichtung (17) weist eine Auflage (18) für die Schicht (3) mit einem verstellbaren und im Ausführungsbeispiel von Figur 5 bis 8 zentralen Drückelement (19) und einem randseitigen Niederhalter (20) auf. Die Auflage (18) kann z.B. als ebener Ablagetisch ausgebildet sein. Sie kann auch eine Heizeinrichtung (21) beinhalten, die der Übersicht halber nicht im Einzelnen dargestellt ist. Das Drückelement (19) ist z.B. als vertikal bzw. normal zur Auflageoberfläche ausfahrbarer Stempel (19') mit einem geeigneten Antrieb und einem Stempelkopf (19") mit einer gerundeten Oberfläche ausgebildet. Die Niederhalter (20) sind z.B. an gegenüber liegenden Rändern (18',18") der Auflage angeordnet und als randseitige Klammern mit Zustellantrieben ausgebildet. Sie halten den Schichten- bzw. Trägerrand gegen den ausfahrenden Stempel (19') fest. Durch das z.B. zentrale Drückelement (19) erhält der Träger (3) die gezeigte Wölbung (22). Durch den steuerbaren Antrieb des Drückelements oder Stempels (19,19') kann die Wölbung (22) relaxiert werden. Der Antrieb kann z.B. ein Zylinder, ein Motor mit Getriebe oder dgl. sein. Die Handhabungseinrichtung (26) fungiert als Andrückvorrichtung (25) und presst mit der Tragplatte (30) die Schicht (4) bzw. die ein oder mehreren solaraktiven Elemente von oben auf die gewölbte Trägeroberfläche und die dort zuvor aufgebrachte Verbindungsmasse (5). Durch Relaxation der Wölbung (22) und entsprechendes Nachführen der Trageinrichtung (29) und der Schicht (4) findet der vorbeschriebene Abwälz- und Verbindungsvorgang statt, wobei am Ende die verbundenen Schichten (3,4,5) die in Figur 7 gezeigte Planlage einnehmen und das Drückelement (19) eingefahren ist.

Die Auftragvorrichtung (33) bringt in der gezeigten Ausführungsform eine fließfähige und z.B. pastöse Verbindungsmasse (5), insbesondere eine Silikonmasse, auf der Schicht bzw. dem Träger (3) auf. Dies kann bei plan liegendem oder bei gewölbtem Träger (3) geschehen. Die Auftragvorrichtung (33) weist einen oder mehrere Vorratsbehälter (36) für die Verbindungsmasse (5) bzw. für deren Einzelkomponenten bei einer etwaigen Mischungsbildung auf. Ferner ist eine Dosiervorrichtung (34) vorhanden, welche die Austrittsmenge und die Verteilung der Verbindungsmasse (5) auf der Schicht (3) bestimmt. Die Dosiervorrichtung (34) kann eine oder mehrere Düsen (35) für den Massenauftrag haben. Diese können mittels einer geeigneten Handhabungs- und Bewegungseinrichtung in einer oder mehreren, insbesondere zwei Bewegungsachsen relativ zur Schicht (3) bewegt werden.

Der Massenauftrag kann in Bahnen oder Raupen erfolgen, wobei die Wölbungsrelaxation für die Verdrängung und Verteilung des Raupenmaterials sorgt. In einer abgewandelten Ausführungsform kann ein Massenauftrag mit einer Rakel oder dgl. realisiert werden, wobei eine weitgehend homogene Schicht (5) der Verbindungsmasse gebildet wird. In einer weiteren nicht dargestellten Abwandlung kann die Auftragvorrichtung (33) eine kompressible Folie oder eine andere Art von zusammenhängender Massenbahn auf der Schicht (3) auftragen.

Die Applikation weiterer Schichten (6,7) an der Basiskomponente (1') des Solarmoduls (1) kann in beliebig geeigneter Weise erfolgen. Beispielsweise können von der Handhabungseinrichtung (26) eine Verbindungsfolie (7) und anschließend eine plattenförmige Deckschicht (6) aufgelegt werden.

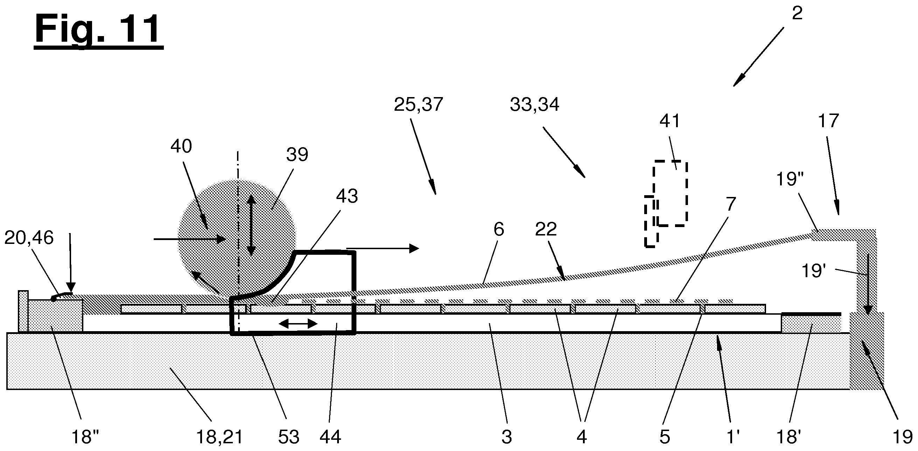

Figur 11 bis 13 zeigen eine hierfür eingesetzte Aufbringvorrichtung (37), mit der eine plattenförmige oder folienförmige Deckschicht (6) auf der Basiskomponente (1') und auf der Rückseite der Schicht (4) aufgebracht wird.

Bei der Ausführungsform von Figur 11 wird eine plattenförmige und wölb- oder biegbare Deckschicht (6) aufgebracht, die aus Glas, Kunststoff oder einem anderen geeigneten Material bestehen kann. Mittels einer Dosiereinrichtung (41) ist zunächst eine Verbindungsschicht (7), z.B. ein pastöser Klebstoff (42), auf der Oberseite bzw. Rückseite der Schicht (4) der solaraktiven Elemente aufgebracht worden. Dies kann vorab in einem Flächenauftrag, mittels Raupen oder dgl. oder auch in anderer Weise geschehen. Anschließend wird die Deckschicht (6) aufgelegt, was z.B. durch die Handhabungseinrichtung (26) der vorbeschriebenen Ausführungsbeispiele geschehen kann. Die Bändchen (16) können zuvor durch die Deckschicht (6) durchgesteckt sein. Bei diesem Anlegen der Deckschicht (6) kommt ggf. eine Variante einer Wölbungseinrichtung (17) zum Einsatz, mit der die Deckschicht (6) eine Wölbung (22) erhält. Die Wölbungseinrichtung (17) kann eine Fixiereinrichtung (46) am einen Randbereich (18") der Auflage (18) aufweisen, welche das eine Ende bzw. den einen Rand der Deckschicht (6) festhält. Die Fixiereinrichtung (46) kann wie der Niederhalter (20) ausgebildet sein. Ein am anderen Randbereich (18') des Unterbaus (18) angeordnetes Drückelement (19) kann am gegenüberliegenden Ende oder Rand der Deckschicht (6) positioniert sein und aus einem vertikal oder quer zur Auflagenoberfläche ausfahrbaren Stempel (19') und einem Stempelkopf (19") oder dgl. bestehen, auf dem der Schichtenrand aufliegt. Hierüber wird der Schichtenrand angehoben und die Wölbung (22) ausgehend vom fixierten (46) Rand gebogen. Die Fixiereinrichtung (46) und das Drückelement (19) greifen an gegenüberliegenden Schichtflächen, insbesondere an Ober- und Unterseite an. Das Drückelement (19) kann alternativ in anderer Weise ausgebildet sein und kann statt Druckkräften Zugkräfte entwickeln.

Die Anbringvorrichtung (37) bzw. die Wölbungseinrichtung (17) weisen in diesem Fall auch ein Andrückelement (39) auf, welches auf die Rückseite der Deckschicht (6) einwirkt und z.B. als drehbare und ggf. rotatorisch angetriebene Walze ausgebildet ist. Mittels einer Bewegungseinrichtung (40) kann das Andrückelement (39) vom fixierten Schichtenrand und vom Randbereich (18") aus entlang der Auflage (18) und der Deckschicht (6) zum anderen Randbereich (18') hin bewegt und zugleich gegen den Schichtrücken angedrückt werden. Die Relaxation der Deckschicht (6) erfolgt durch Vorschub des Andrückelements (39) und eine darauf abgestimmte Einfahrbewegung des Drückelements oder Stempels (19,19'). Eine Seitenbegrenzung (44), z.B. in Form von mit dem Andrückelement (39) mitbewegten seitlichen Schilden (44) kann die Klebstoffverdrängung begrenzen.

In Abwandlung der gezeigten Ausführungsform kann die Dosiereinrichtung (41) mitbewegt werden und das Material der Verbindungsschicht (7) in einen Zwickel (23,45) zwischen der Deckschicht (6) und der Schicht (4) im Abwälzbereich einbringen.

Die Verbindungsschicht (7) kann in entsprechender Weise wie die vorbeschriebene Verbindungsmasse (5) ausgebildet und aufgebracht werden. Es kann sich auch hier um eine silikonbasierte Klebemasse handeln. Sie kann lichtdurchlässig und ggf. transparent sein, was allerdings nicht zwingend erforderlich ist. Die Dosiereinrichtung (41) kann zusätzlich zu der Dosiereinrichtung (34) vorhanden sein oder kann von dieser gebildet werden.

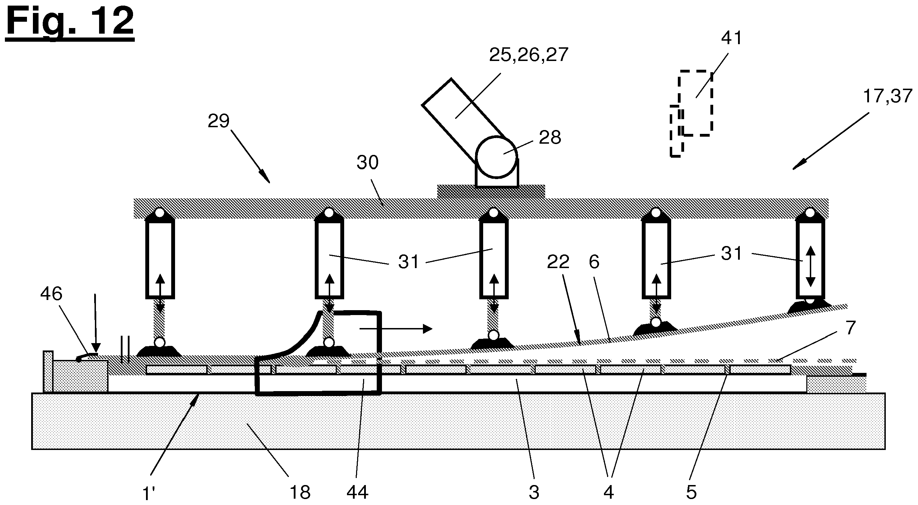

In der Variante von Figur 12 wird ebenfalls eine biegbare und plattenförmige Deckschicht (6) auf die Basiskomponente (1') aufgebracht, wobei auch eine Wölbungseinrichtung (17) zum Einsatz kommt. Diese ist in Abwandlung zu Figur 11 als flexible Trageinrichtung (29) ausgebildet und wird an der Hand (28) einer Handhabungseinrichtung (26), insbesondere eines mehrachsigen Manipulators oder Roboters der vorbeschriebenen Art, gehalten. Die Trageinrichtung (29) besitzt hier eine steife Tragplatte (30) mit daran angeordneten verstellbaren Greifelementen (31), deren Saug- oder Wirkseite den Abstand zur Tragplatte (30) mittels ausfahrbarer Stempel oder dgl. ändern kann. Je nach Ausfahrlänge ergibt sich hierdurch eine andere Greifkontur, die zur Bildung der gezeigten Wölbung (22) herangezogen wird. Zum Relaxieren der Wölbung (22) und der Deckschicht (6) werden die Greifelemente (31) gesteuert ausgefahren. Der eine Schichtenrand wird auch hier von einer Fixiereinrichtung (46) ggf. an der Unterlage gehalten. Eine Seitenbegrenzung (44) kann stationär angeordnet oder mit der Relaxation bzw. der Greiferbetätigung abgestimmt mitbewegt werden.

Die in Figur 11 und 12 gezeigte Wölbungseinrichtung (17) ist nicht nur für die Aufbringvorrichtung (37) und die Deckschicht (6) geeignet. Sie lässt sich gemäß Figur 14 bis 18 auch als Variante zu den vorbeschriebenen Ausführungsbeispielen für die Schichten (3,4) einsetzen.

In weiterer Abwandlung der Ausführungsvarianten von Figur 11 und 12 kann die Deckschicht (6) eine höhere Biegeelastizität und ggf. eine kleinere Dicke aufweisen, wobei sie z.B. als Folienzuschnitt oder dgl. ausgebildet ist.

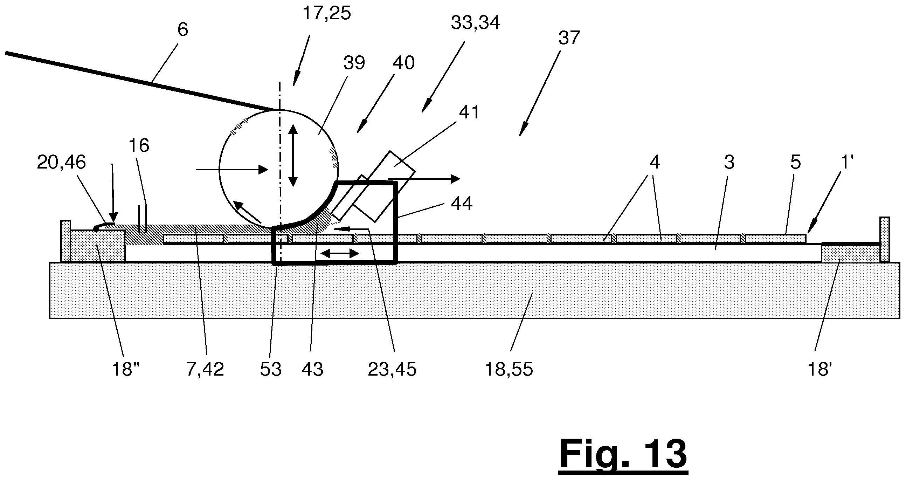

Figur 13 zeigt eine dritte Variante zum Aufbringen einer biegeelastischen und insbesondere in Form einer Folie vorliegenden Deckschicht (6) mittels einer pastösen und als Klebstoff ausgebildeten Verbindungsschicht (7) auf der Basiskomponente (1') und auf der Rückseite der Schicht (4). Die Deckschicht (6) wird z.B. von einem Folienwickel (38) zugeführt und mittels einer Fixiereinrichtung (46) an einem Rand des Trägers (3) bzw. des Solarmoduls (1) festgehalten. Die Bändchen (16) können zuvor durch die Deckschicht (6) durchgesteckt sein. Die Deckschicht (6) wird mit Hilfe eines über die Basiskomponente (1') mittels einer Bewegungseinrichtung (40) hinwegbewegten Andrückelements (39) zugeführt und angedrückt. Das Andrückelement (39) kann eine Rakel oder eine rotierende Walze sein, die einen Aufwälzeffekt erzeugt. In einem Vorauftrag oder in den Wälzzwickel (45) wird mittels einer Dosiereinrichtung (41) ein fließfähiger Klebstoff (42) eingebracht, der hier einen Wulst (43) bildet und der gleichmäßig auf der Schicht (4) verteilt wird. Eine Seitenbegrenzung (44), z.B. in Form von mit dem Andrückelement (39) mitbewegten seitlichen Schilden (44) kann die Klebstoffverdrängung begrenzen. Die Walze (39) kann einen steuerbaren Drehantrieb besitzen und kann außerdem eine Saugeinrichtung beinhalten, die durch schematisch dargestellte Saugöffnungen am Walzenmantel symbolisiert wird. Die Bewegungseinrichtung (40) sorgt auch für ein vertikales Andrücken der Deckschicht (6) und für den Walzentransport in Längs- oder Vorschubrichtung unter Einsatz eines Schlittens oder eines anderen geeigneten Fortbewegungsmittels.

Die in Figur 13 gezeigte Wälz- und Anbringtechnik kann auch zur Bildung flexibler Basiskomponenten (1') in Abwandlung von Figur 1 bis 7 eingesetzt werden. Hierbei wird auf eine Schicht (4) von solaraktiven Elementen frontseitig eine lichtdurchlässige bzw. transparente Trägerschicht (3) in biegeelastischer, folienartiger Ausführung mittels einer Verbindungsmasse (5) aufgebracht.

Durch die Verbindungsschichten (5,7) erfolgt eine feste gegenseitige Verbindung der anderen Schichten (3,4,6). Zusätzlich kann in einem Laminator oder dgl. ein thermisches Verbacken stattfinden. Die fließfähigen Massen (5,6) können auch am Modulrand für einen dichten Abschluss sorgen und hier ggf. getrimmt werden.

Die Heizeinrichtung (21) kann zum Verfestigen der Verbindungsmasse (5) nach deren Auftrag und zum Verfestigen des Schichtenverbundes eingesetzt werden. Sie kann gesteuert werden und kann ggf. auch in ihrer Leistung verändert werden. Sie kann insbesondere zum Erwärmen der aufgetragenen Verbindungsmasse (5) und zur Verbesserung von deren Fließfähigkeit und Massenverteilung eingesetzt werden. Die Leistung kann hierbei reduziert sein. Zum nachfolgenden Verfestigen und insbesondere Warmaushärten der Verbindungsmasse (5) kann die Heizleistung erhöht werden. Desgleichen kann auch zum anschließenden Verfestigen bzw. Aushärten der Verbindungsschicht (7) die Heizeinrichtung (21) wieder benutzt werden.

Von der Handhabungseinrichtung (26) kann anschließend das fertige Solarmodul (1) abtransportiert werden. Die Handhabungseinrichtung (26) kann ferner Zusatzfunktionen ausführen. Sie kann einerseits zum Aufnehmen und Prüfen der Strings (12) an einer geeigneten optischen Prüfvorrichtung mit Spannungsaufschaltung auf den String (12) benutzt werden. Sie kann ggf. auch zur Schaffung der elektrischen Leitungsverbindungen benutzt werden, indem z.B. eine integrierte Löteinrichtung vorhanden ist, mit der die Bändchen (16) an die rückseitigen Leitungen (15) gelötet werden oder die Leitungen (15) der Strings (12) untereinander querverbunden und gelötet werden. Auch ein Schweißen statt Löten oder einer andere Verbindungstechnik sind möglich.

Figur 14 bis 18 zeigen eine Variante der Fertigungseinrichtung (2) und des Fertigungsverfahrens gegenüber der Ausführungsform von Figur 5 bis 8. Die Abwandlungen betreffen insbesondere die Auflage (18) und die Wölbungseinrichtung (17) sowie den Schichtenaufbau. Der Fertigungsprozess kann wie in den vorbeschriebenen Ausführungsbeispielen innerhalb einer einzigen Station mittels einer einzigen und vorzugsweise stationären Auflage (18) durchgeführt werden. Die Wölbungseinrichtung (17) weist ein Drückelement (19) auf, welches in dieser Ausführungsform am einen Randbereich (18') der Auflageplatte (54) angeordnet ist. An einem anderen und insbesondere gegenüberliegenden Randbereich (18") befindet sich ein Niederhalter (20) bzw. eine Fixiereinrichtung (46). Diese Anordnung entspricht der vorbeschriebenen Ausführung von Figur 11, wobei auch das Andrückelement (39) mit der Bewegungseinrichtung (40) und die Aufbringeinrichtung oder Auftrageinrichtung (33) sowie die Dosiervorrichtung (34,41) in entsprechender Weise ausgebildet sein können.

Bei der Variante von Figur 14 bis 18 wird mindestens ein solaraktives Element (4), vorzugsweise ein String oder eine Matrix von Solarzellen, die bereits mit verbindenden elektrischen Leitungen (15) bzw. Bändchen (16) versehen sind, auf der Auflageplatte (54) abgelegt. Dies kann durch die vorbeschriebene Handhabungseinrichtung (26) und die Trageinrichtung (29) geschehen. Die Leitungen (15) bzw. Bändchen (16) weisen in diesem Fall nach unten zur Auflageplatte (54). Die Auflageplatte (54) besitzt eine Führung (57) für das solaraktive Element (4), das hierüber exakt positioniert werden kann. Die Führung (57) kann z.B. aus einem Netz von Nuten bestehen, die der Formgebung der Leitungen (15) entsprechen und diese formschlüssig oder mit Übermaß aufnehmen. Die Auflageplatte (54) kann eine bis auf die Führung (57) ebene funktionale Oberfläche (61) aufweisen, die aus einem für die Verbindungsmasse (5) inerten und nicht haftenden Material, z.B. Teflon oder dgl., besteht.

Die Solarzellen (8) können auf den planen Oberflächen- oder Auflagebereichen (60) zwischen den Nuten plan aufliegen. Sie können alternativ in schalenförmigen Vertiefungen aufgenommen werden, die ein Bestandteil der Führung (57) sein können.

In der Auflage (18) ist außerdem eine Saugeinrichtung (55) angeordnet, die an der Oberfläche (61) der Auflageplatte (54) mehrere Saugöffnungen (56) aufweist. Diese können im Bereich der Führung (57) und insbesondere daneben im jeweiligen Auflagebereich (60) der Solarzellen (8) angeordnet sein. Die Saugeinrichtung (55) saugt die Solarzellen (8) an und kann auch in den dazwischenliegenden freien Bereichen (14) wirken.

Die Auflageplatte (54) kann zumindest im Auflagebereich (60) der Solarzellen (8) eine profilierte Plattenoberfläche (61) aufweisen, die ein Ansaugen von Luft aus den freien Bereichen (14) unter den Randbereich (64) der Solarzellen (8) ermöglicht. Die Profilierung kann durch eine entsprechende Oberflächenrauigkeit der Plattenoberfläche (61) oder auf andere Weise gebildet werden. Zwischen der Solarzelle (8) und ihrem Auflagebereich (60), insbesondere in der Plattenoberfläche (61), werden ein Vielzahl kleiner Luftkanäle (62) für den Durchtritt einer Luftströmung (63) vom Solarzellenrand (64) zu einer Ansaugöffnung (56) gebildet. Eine im Freiraum (14) befindliche Verbindungsmasse (5,7) kann ebenfalls an den Zellenrand (64) angesaugt und ggf. ein Stück in die Luftkanäle (62) eingesaugt werden, wobei sie wie beim Ausführungsbeispiel von Figur 11 bis 13 den Zellenrand (64) hintergreifen kann.

Die Saugeinrichtung (55) kann steuerbar sein und hierfür mit der Stationssteuerung, insbesondere der Robotersteuerung verbunden sein. Die Saugöffnungen (56) an der Plattenoberfläche (61) können dabei in der Saugleistung und/oder Saugrichtung getrennt voneinander steuerbar sein. Insbesondere kann die Strömungsrichtung umgekehrt werden, um die verbundenen Schichten (3,5,5) leichter abnehmen zu können.

Bei diesem Ausführungsbeispiel ist die Reihenfolge der Schichtenbildung (4,5,3) vertauscht gegenüber dem vorbeschriebenen Beispiel. Zuerst wird die solaraktive Schicht (4) auf die Auflage (18) oder die Auflageplatte (54) gelegt und darüber anschließenden die transparente Verbindungsschicht (5) und dann die ggf. lichtdurchlässige plattenartige Schicht bzw. der Träger (3) appliziert.

Die Ausbildung der Fertigungseinrichtung (2) und der Zelle kann im wesentlichen die gleiche wie in Figur 1 sein. Die Auftragvorrichtung (33) weist auch in dieser Ausführungsform eine Fördereinrichtung (50) für eine Dosiereinrichtung (34,41) auf. Hierfür kann eine Führung (51) zur einachsigen oder mehrachsigen Bewegung der Dosiereinrichtung (41) relativ zum solaraktiven Element (4) vorgesehen sein, die z.B. als einachsig beweglicher Schlitten oder als zweiachsig beweglicher Kreuzschlitten ausgebildet ist, der an Schienen längs der Auflage (18) und ggf. an einem Schlittenbalken quer dazu mit einem oder mehreren Antrieb(en) (52) vom einen Randbereich (18") zum anderen Randbereich (18') verfahrbar ist. Die Auftragvorrichtung (33) trägt auf dem abgelegten solaraktiven Element (4) eine pastöse oder flüssige oder ggf. auch komprimierbare folienartige Verbindungsmasse (5) auf, was in einem flächigen Auftrag oder in Form einer mäandrierenden Raupe geschehen kann.

Die Wölbungseinrichtung (17) weist ein entlang der Auflage (18) mittels einer Bewegungseinrichtung (40) bewegliches Andrückelement (39) auf, welches eine Doppelfunktion als Andrückeinrichtung (25) und als zusätzliche Aufbringvorrichtung (37) für eine Deckschicht (6) haben kann.

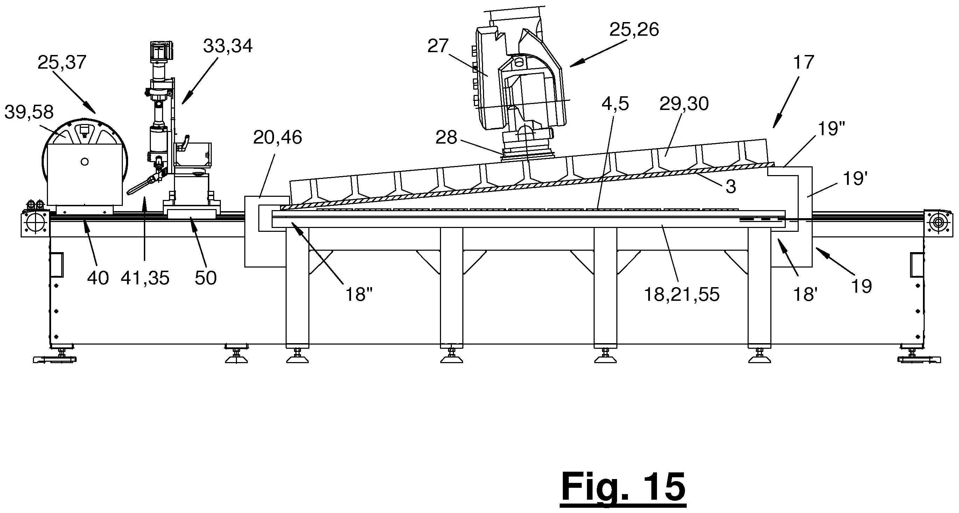

Die Handhabungseinrichtung (26) führt gemäß Figur 15 mit der Trageinrichtung (29) und einer ggf. auswechselbaren und an die jeweilige Schicht adaptierbaren Tragplatte (30) eine plattenartige Schicht (3), insbesondere eine lichtdurchlässige Glas- oder Kunststoffplatte, der Auflage (18) zu und übergibt sie an die Wölbungseinrichtung (17). Dies kann bei einem eingefahrenen oder ausgefahrenen Drückelement (19) geschehen. Die plattenartige Schicht (3) wird zumindest mit einem Rand am Randbereich (18") der Auflage (18) an der Auflageplatte (54) oder auf einer der zuvor applizierten Schichten (4,5) aufgelegt und mit einer steuerbaren Fixiereinrichtung (46) oder einem Niederhalter (20) fixiert. Der andere gegenüberliegende Randbereich der Schicht (3) wird auf dem Stempelkopf (19") abgelegt. Figur 15 zeigt den Stempelkopf (19") zur besseren Unterscheidung der einzelnen Vorrichtungsbestandteile in einer bereits ausgefahrenen Position. Bevorzugt erfolgt die Ablage auf einem eingefahrenen Stempelkopf (19"), der nach Lösen der Handhabungseinrichtung (26) und der Trageinrichtung (29) ausfährt und die plattenartige Schicht (3) in der zu Figur 11 vorbeschriebenen Weise biegt und deren Wölbung (22) erzeugt.

Das vorzugsweise als drehbare und ggf. angetriebene Walze ausgebildete Andrückelement (39) wird dann in der vorbeschriebenen Weise entlang der gewölbten plattenartigen Schicht (3) zum Randbereich (18') hin bewegt und drückt diese auf die Verbindungsschicht (5), wobei zugleich in einer mit dem Walzenvorschub abgestimmten Bewegung das Drückelement (19) abgesenkt wird.

Die hierdurch gebildete Basiskomponente (1') mit den Schichten (3,4,5) wird anschließend von der Handhabungseinrichtung (26) gewendet und mit einer Deckschicht (6) sowie ggf. einer weiteren Verbindungsschicht (7) versehen. Dies kann wiederum in der in Figur 11,12 oder 13 gezeigten Weise geschehen. Die ein oder mehreren Verbindungsschichten (5,7) können in der vorbeschriebenen Weise verfestigt und insbesondere ausgehärtet werden. Dies kann insbesondere mittels einer in die Auflage (18) integrierten Heizeinrichtung (21) geschehen.

Das fertige mehrschichtige Solarmodul (1) kann dann von der Handhabungseinrichtung (26) abtransportiert werden, wonach der Fertigungszyklus erneut beginnt. Um die Rüst- und Transportzeiten zu verkürzen, kann die Handhabungseinrichtung (26) aus mehreren Robotern (27) bestehen. Sie kann ggf. auch mehrere Auflagen (18) bedienen, die zeitversetzt mit den Schichten (3,4,5,6,7) beschickt werden.

In Abwandlung der vorbeschriebenen Ausführungsform von Figur 14 bis 18 kann der Schichtaufbau verändert und auf ein auf der Auflageplatte (54) abgelegtes solaraktives Element (4) eine Verbindungsmasse (7) und eine Deckschicht (6) in der beschriebenen Weise aufgebracht werden.

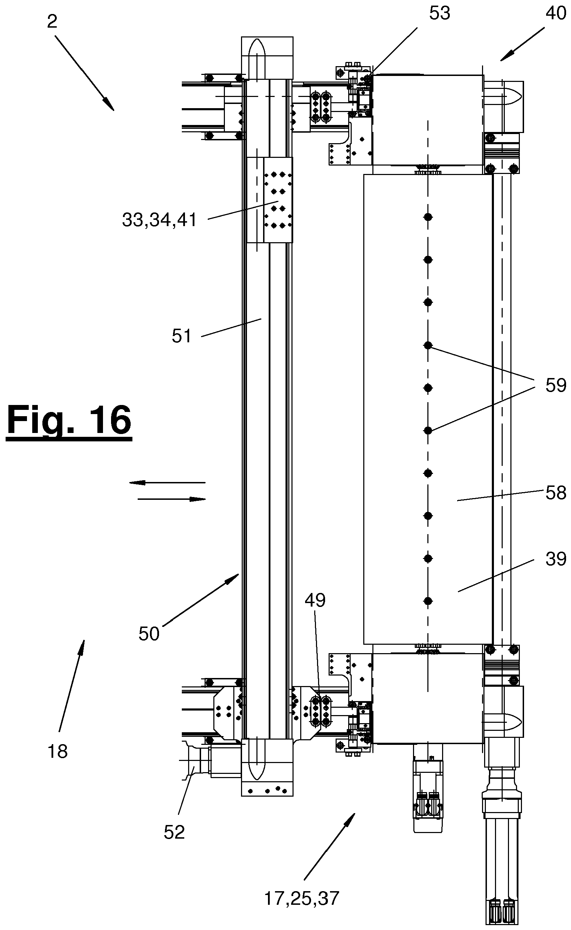

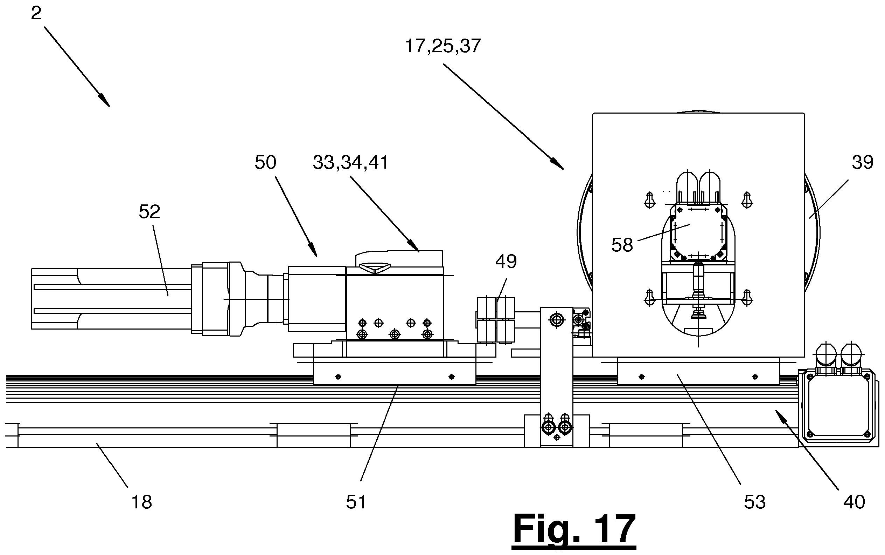

Figur 16 und 17 zeigen Details einer Ausbildung der Bewegungseinrichtung (40) und der Fördereinrichtung (50) für die Anbring- oder Auftragvorrichtung (33). Diese sind koppelbar und können einzeln oder gemeinsam bewegt werden. Zur Kopplung und Verbindung kann eine ggf. mehrfach vorhandene steuerbare Kupplung (49) vorhanden sein. Bei einer solchen Kopplung genügt ein einzelner Antrieb (52) für die Fahrbewegung entlang der Auflage (18), wobei dieser Antrieb (52) z.B. an der Fördereinrichtung (50) angeordnet ist. Im gekoppelten Zustand wird das Andrückelement (39) mitgeschleppt, wobei zugleich ein definierter Abstand hergestellt wird. Die Einheit kann gemäß Figur 1 und 14 beim Auflegen der plattenartigen Schicht (3) und Bildung der Wölbung (22) hinter und außerhalb der Auflageplatte (54) positioniert sein.

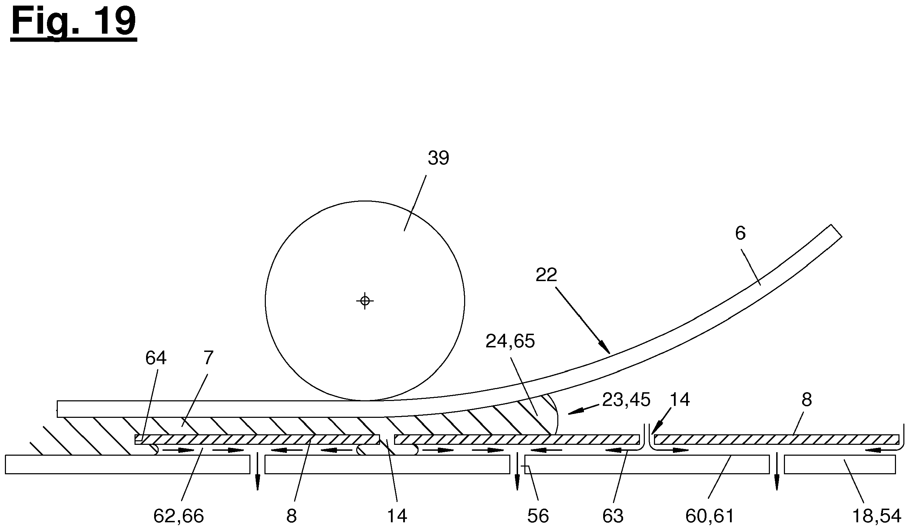

Figur 19 zeigt eine schematische Darstellung zum Erläutern der vorgenannten Ausführungsform einer Vorrichtung und eines Verfahrens zum Herstellen einer Schichtanordnung mit lichtaktiven Elementen, insbesondere eine Solarzellen (8), für ein mehrschichtiges Modul.

Die Solarzellen (8) sind auf der Auflage (18) angeordnet, mit der eine Arbeitsplatte oder Arbeitsfläche gebildet ist. In der Auflage sind die Saugöffnungen (56) gebildet, die zum Teil oder alle an ein nicht dargestelltes Druckluftsteuersystem angeschlossen sind. Die Saugöffnungen (56) sind mit einer sich in x- und y-Richtung der Auflage (18) erstreckenden Anordnung hergestellt.

Figur 19 zeigt nun den Prozess des Relaxierens einer plattenförmigen Schicht (6) über der Anordnung von Solarzellen (8). Die Wölbung (22) läuft von links nach rechts über die Anordnung von Solarzellen (8), derart, dass die gewölbte plattenförmige Schicht (6) schließlich auf der Anordnung von Solarzellen (8) relaxiert. Bei diesem Prozess läuft im Zwickel (23) eine stehende Welle (65) in Form des Wulstes (24) über die Anordnung von Solarzellen (8). Das Einarbeiten der flüssigen oder pastösen Verbindungsmasse (7) in Zwischenräume (14) zwischen den Solarzellen (8) wird in der vorerwähnten Weise dadurch unterstützt, dass die Saugöffnungen (56) während des Relaxierens der plattenförmigen Schicht (6) mit einem Unterdruck beaufschlagt werden. Auf diese Weise wird die Luft aus den Zwischenräumen (14) abgesaugt, was in Figur 19 schematisch mit Hilfe von Pfeilen gezeigt ist. Gleichzeitig verhindern die mit dem Saugdruck beaufschlagten Saugöffnungen (56) das Ausbilden von Blasen in der die Solarzellen (8) einbettenden Verbindungsmasse (7). Auch sich beim Einarbeiten der Verbindungsmasse eventuell bildende Lufteinschlüsse werden mit Hilfe des Unterdrucks wieder aufgelöst.

Aus Figur 19 ergibt sich, dass die Verbindungsmasse (7) aufgrund des Saugdrucks um Kanten (64) der Solarzellen (8) auch in einen Bereich (66) zwischen der Auflage (18) und den Solarzellen (8) hineingezogen wird. Auf diese Weise werden Rand- oder Kantenbereiche (64) der Solarzellen (8) ebenfalls in die Verbindungsmasse (7) eingebettet.

Wenn der Schichtverbund aus der Anordnung von Solarzellen (8), der Verbindungsmasse (7) und der plattenförmigen Schicht (6) hergestellt ist, die plattenförmige Schicht also vollständig relaxiert ist und in eine ebene Form übergegangen ist, können die Saugöffnungen (56) mit einem Überdruck beaufschlagt werden, um das Lösen des hergestellten Schichtverbundes von der Auflage (18) zu unterstützen.

Sowohl im Fall des Unterdrucks als auch im Fall des Überdrucks kann vorgesehen sein, die Saugöffnungen (56) einzeln oder in Gruppen mit unterschiedlichen Drücken zu beaufschlagen, um im Bereich der Arbeitsfläche der Auflage (18) lokal unterschiedliche Druckverhältnisse auszubilden. Eine solche lokale Verteilung kann dann während des Herstellungsprozesses auch einmal oder mehrfach verändert werden. Hierzu werden die Saugöffnungen (55) einzeln oder in Gruppen entsprechend angesteuert.

Abwandlungen der gezeigten und beschriebenen Ausführungsformen sind in verschiedener Weise möglich. Zum einen kann die Wölbungseinrichtung (17) in anderer Weise ausgebildet sein und funktionieren. Die Wölbung (22) kann statt durch mechanisches Biegen auch auf andere Weise erzeugt werden, was u.a. von der Art und Ausbildung der gewölbten Schicht (3,4,6) abhängt. Insbesondere kann die Tragplatte (30) in sich mehrgliedrig und beweglich sein und eine Wölbungseinrichtung (17) darstellen. Ein Abbiegen kann hierbei im Spaltbereich und an den Bändchen oder sonstigen Elementverbindungen (16) stattfinden.

Die in der vorstehenden Beschreibung, den Ansprüchen und der Zeichnung offenbarten Merkmale der Erfindung können sowohl einzeln als auch in beliebiger Kombination für die Verwirklichung der Erfindung in ihren verschiedenen Ausführungen von Bedeutung sein.

### BEZUGSZEICHENLISTE

- 1: Solarmodul
- 1': Basiskomponente
- 2: Fertigungseinrichtung
- 3: Schicht, Träger, Glasplatte
- 4: Schicht, solaraktives Element
- 5: Schicht, Verbindungsmasse, Siliconschicht
- 6: Schicht, Deckschicht, Glasplatte
- 7: Schicht, Verbindungsschicht
- 8: Solarzelle
- 9: Hybridanordnung
- 10: lichtreaktives Teil
- 11: Thermoteil, wärmeabsorbierende Lage
- 12: String, Reihe
- 13: Matrix
- 14: Abstand, Spalt
- 15: Leitung
- 16: Bändchen
- 17: Wölbungseinrichtung, Biegeeinrichtung
- 18: Auflage, Tisch
- 18': Randbereich
- 18": Randbereich
- 19: Drückelement
- 19': Stempel
- 19": Stempelkopf
- 20: Niederhalter
- 21: Heizeinrichtung
- 22: Wölbung
- 23: Zwickel
- 24: Wulst
- 25: Andrückvorrichtung
- 26: Handhabungseinrichtung
- 27: Manipulator, Roboter
- 28: Hand
- 29: Trageinrichtung
- 30: Tragplatte
- 31: Greifelement, Sauger
- 32: Saugöffnung
- 33: Auftragvorrichtung
- 34: Dosiervorrichtung
- 35: Düse
- 36: Vorratsbehälter
- 37: Aufbringvorrichtung
- 38: Folienwickel
- 39: Andrückelement, Walze
- 40: Bewegungseinrichtung
- 41: Dosiereinrichtung
- 42: Klebstoff
- 43: Wulst
- 44: Seitenbegrenzung, Schild
- 45: Wälzzwickel
- 46: Fixiereinrichtung, Niederhalter
- 47: Stringablage
- 48: Matrixablage
- 49: Kopplung, steuerbare Kupplung
- 50: Fördereinrichtung
- 51: Führung, Schlitten für Dosiereinrichtung
- 52: Antrieb
- 53: Führung, Schlitten für Andrückelement
- 54: Auflageplatte
- 55: Saugeinrichtung für Auflage
- 56: Saugöffnung an Auflageplatte
- 57: Führung für Solarelement, Nut
- 58: Saugeinrichtung für Andrückelement
- 59: Saugöffnung an Andrückelement
- 60: Auflagebereich
- 61: Plattenoberfläche
- 62: Luftkanal
- 63: Luftströmung
- 64: Rand von Solarzelle
- 65: stehende Welle
- 66: Bereich zwischen Auflage und Solarzelle

## Patentansprüche

1. Fertigungseinrichtung für mehrschichtige (3,4,5,6,7) Module (1), insbesondere Solarmodule, oder für eine mehrschichtige Basiskomponente (1') eines Moduls (1) mit einer lichtdurchlässigen plattenförmigen Schicht (3,6) und einer Anordnung von lichtaktiven Elementen (4) mit Zwischenräumen zwischen den lichtaktiven Elementen (4), wobei die Fertigungseinrichtung (2) den Schichtaufbau bildet und eine Aufbringvorrichtung (33) für eine flüssige oder pastöse Verbindungsmasse (5,7) sowie eine steuerbare Wölbungseinrichtung (17) zum Biegen einer plattenförmigen Schicht (3,6), insbesondere einer Glasplatte (3,6), aufweist, wobei die Wölbungseinrichtung (17) eine Auflage (18), insbesondere einen Tisch, für die Anordnung von lichtaktiven Elementen (4) und für eine plattenförmige Schicht (3,6) mit einem randseitigen Niederhalter oder einer Fixiereinrichtung (20,46) und mit einem höhenverstellbaren Drückelement (19) aufweist, die an einer plattenförmigen Schicht (3,6) angreifen, wobei die Auflage (18) eine steuerbare Saugeinrichtung (55) mit Saugöffnungen (56) im Auflagebereich (60) der lichtaktiven Elemente (4) aufweist, wobei die lichtaktiven Elemente (4) in die Verbindungsmasse (5,7) blasenfrei einbettbar sind, derart, dass wenigstens ein Teil ihrer Außenfläche von der Verbindungsmasse (5,7) bedeckt wird und die Wölbung der plattenförmigen Schicht (3,6) auf der Anordnung von lichtaktiven Elementen (4) mit der hierauf aufgebrachten Verbindungsmasse (5,7) relaxierbar ist.

2. Fertigungseinrichtung nach Anspruch 1, **dadurch gekennzeichnet, dass** die Wölbungseinrichtung (17) eine veränderliche, insbesondere relaxierbare Wölbung oder Krümmung einer plattenförmigen Schicht (3,6) erzeugt.

3. Fertigungseinrichtung nach Anspruch 1 oder 2, **dadurch gekennzeichnet, dass** ein Drückelement (19) an einem Randbereich (18') der Auflage (18) und ein Niederhalter oder eine Fixiereinrichtung (20,46) an einem anderen, insbesondere einem gegenüber liegenden Randbereich (18") der Auflage (18) angeordnet ist.

4. Fertigungseinrichtung nach Anspruch 1, 2 oder 3, **dadurch gekennzeichnet, dass** die Wölbungseinrichtung (17) ein Andrückelement (39) aufweist, welches auf die Rückseite einer plattenförmigen Schicht (3,6) einwirkt, wobei ein Vorschub des Andrückelements (39) entlang der plattenförmigen Schicht (3,6) und eine Einfahrbewegung des Drückelements (19) der Wölbungseinrichtung (17) zur gesteuerten Relaxation der Schichtwölbung (22) aufeinander abgestimmt sind.

5. Fertigungseinrichtung nach einem der vorhergehenden Ansprüche, **dadurch gekennzeichnet, dass** für ein Andrückelement (39) der Wölbungseinrichtung (17) eine Bewegungseinrichtung (40) vorgesehen ist, mit der das Andrückelement (39) entlang einer plattenförmigen Schicht (3,6) bewegbar und zugleich gegen deren Schichtrücken andrückbar ist.

6. Fertigungseinrichtung nach einem der vorhergehenden Ansprüche, **dadurch gekennzeichnet, dass** eine Aufbringvorrichtung (33) eine Dosiereinrichtung (44) für eine pastöse oder flüssige Verbindungsmasse (5,7) aufweist.

7. Fertigungseinrichtung nach einem der vorhergehenden Ansprüche, **dadurch gekennzeichnet, dass** die Fertigungseinrichtung (2) eine Heizeinrichtung (21) für die Schichten (3,4,5,6,7) des Moduls (1) aufweist.

8. Fertigungseinrichtung nach einem der vorhergehenden Ansprüche, **dadurch gekennzeichnet, dass** die Fertigungseinrichtung (2) eine Aufbringvorrichtung (37) für weitere Schichten (6,7) auf der anderen Seite einer mehrschichtigen Basiskomponente (1') aufweist.

9. Verfahren zum Herstellen einer Schichtanordnung mit mehreren lichtaktiven Elementen für ein mehrschichtiges Modul, insbesondere Solarmodul, wobei das Verfahren die folgenden Schritte umfasst:
- Ausbilden einer Anordnung von lichtaktiven Elementen auf einer mit Saugöffnungen (56) gebildeten Auflage (18), indem die lichtaktiven Elemente auf der Auflage (18) abgelegt werden,
- Aufbringen einer flüssigen oder pastösen Verbindungsmasse auf die Anordnung von lichtaktiven Elementen und
- Ausbilden eines haftenden Schichtverbundes mit der Anordnung von lichtaktiven Elementen und einer plattenförmigen Schicht, wobei hierbei
- die plattenförmige Schicht mit Hilfe einer Wölbungseinrichtung (17) mit einer Wölbung oder Krümmung auf die Anordnung von lichtaktiven Elementen aufgelegt wird,
- ein wenigstens in Zwischenräume zwischen den auf der Auflage (18) abgelegten lichtaktiven Elemente hinein wirkender Saugdruck über die Saugöffnungen (56) aufgegeben wird, und
- die lichtaktiven Elemente in die Verbindungsmasse blasenfrei eingebettet werden, derart, dass wenigstens ein Teil ihrer Außenfläche von der Verbindungsmasse bedeckt wird, indem die Wölbung der plattenförmigen Schicht auf der Anordnung von lichtaktiven Elementen mit der hierauf aufgebrachten Verbindungsmasse relaxiert und die Verbindungsmasse unter der Saugwirkung des Saugdrucks wenigstens in die Zwischenräume eingearbeitet wird.

10. Verfahren nach Anspruch 9, **dadurch gekennzeichnet, dass** die Verbindungsmasse aufgrund des Saugdrucks wenigstens in umlaufenden Randbereichen der lichtaktiven Elemente bis in einen Bereich blasenfrei gelangt, in welchem die Oberfläche der Auflage und eine zugeordnete Oberfläche der lichtaktiven Elemente sich einander gegenüberliegen.

11. Verfahren nach Anspruch 9 oder 10, **dadurch gekennzeichnet, dass** beim Ausbilden der Anordnung von lichtaktiven Elementen auf der Auflage frontseitig und / oder rückseitig kontaktierte lichtaktiven Elemente abgelegt werden, wobei im Fall der frontseitig kontaktierten lichtaktiven Elemente Kontaktleitungen beim Ablegen der lichtaktiven Elemente in oberflächigen Vertiefungen auf der Auflage angeordnet werden.

12. Verfahren nach einem der Ansprüche 9 bis 11, **dadurch gekennzeichnet, dass** beim Relaxieren der Wölbung oder Krümmung der plattenförmigen Schicht in einem Zwickel zwischen der Anordnung von lichtaktiven Elementen auf der Auflage (18) und der der Anordnung von lichtaktiven Elementen zugewandten Oberfläche der plattenförmigen Schicht eine über die Anordnung von lichtaktiven Elementen laufende stehende Welle der Verbindungsmasse erzeugt wird.

13. Verfahren nach einem der Ansprüche 9 bis 12, **dadurch gekennzeichnet, dass** als flüssige oder pastöse Verbindungsmasse eine Verbindungsmasse mit Silikon oder silikonhaltigen Verbindungen verwendet wird.

14. Verfahren nach einem der Ansprüche 9 bis 13, **dadurch gekennzeichnet, dass** beim Ausbilden des haftenden Schichtverbundes ein Vorschub eines Andrückelements (39) entlang der plattenförmigen Schicht und eine Einfahrbewegung eines Drückelements (19) zum gesteuerten Relaxieren der Wölbung oder Krümmung aufeinander abgestimmt eingestellt werden.

15. Verwendung des Verfahrens nach einem der Ansprüche 9 bis 14 beim Herstellen eines mehrschichtigen Moduls mit mehreren lichtaktiven Elementen, insbesondere Solarmodul mit Solarzellen.

## Claims

1. Production device for multilayered (3, 4, 5, 6, 7) modules (1), in particular solar modules, or for a multilayered base component (1') of a module (1) comprising a translucent plate-like layer (3, 6) and an array of photoactive elements (4) with interspaces between the photoactive elements (4), wherein the production device (2) forms the layered structure and comprises an applicator (33) for a liquid or pasty bonding compound (5, 7) and a controllable arching device (17) for bending a plate-like layer (3, 6), in particular a glass plate (3, 6), wherein the arching device (17) comprises a support (18), in particular a table, for the array of photoactive elements (4) and for a plate-like layer (3, 6), having a holding-down device or a fixing device (20, 46) at the edge and having a height-adjustable pressing element (19), which act on a plate-like layer (3, 6), wherein the support (18) comprises a controllable suction device (55) with suction openings (56) in the supporting area (60) for the photoactive elements (4), wherein the photoactive elements (4) can be embedded in the bonding compound (5, 7) in a bubble-free manner such that at least part of their outer surface is covered by the bonding compound (5, 7) and the arching of the plate-like layer (3, 6) on the array of photoactive elements (4) with the bonding compound (5, 7) applied thereto can be relaxed.

2. Production device according to Claim 1, **characterized in that** the arching device (17) produces a variable, in particular relaxable, arching or curvature of a plate-like layer (3, 6).

3. Production device according to Claim 1 or 2, **characterized in that** a pressing element (19) is arranged at an edge area (18') of the support (18) and a holding-down device or a fixing device (20, 46) is arranged at another, in particular opposite, edge area (18") of the support (18).

4. Production device according to Claim 1, 2 or 3, **characterized in that** the arching device (17) comprises a pressure-exerting element (39), which acts on the rear side of a plate-like layer (3, 6), wherein an advancement of the pressure-exerting element (39) along the plate-like layer (3, 6) and a retracting movement of the pressing element (19) of the arching device (17) are coordinated with one another for the controlled relaxation of the arching (22) of the layer.

5. Production device according to one of the preceding claims, **characterized in that** a moving device (40) is provided for a pressure-exerting element (39) of the arching device (17), with which the pressure-exerting element (39) can be moved along a plate-like layer (3, 6) and at the same time can be pressed against the back of the layer.

6. Production device according to one of the preceding claims, **characterized in that** an applicator (33) comprises a dispensing device (44) for a pasty or liquid bonding compound (5, 7).

7. Production device according to one of the preceding claims, **characterized in that** the production device (2) comprises a heating device (21) for the layers (3, 4, 5, 6, 7) of the module (1).

8. Production device according to one of the preceding claims, **characterized in that** the production device (2) comprises an applicator (37) for further layers (6, 7) on the other side of a multilayered base component (1').

9. Method for producing a layered arrangement comprising a number of photoactive elements for a multilayered module, in particular a solar module, the method comprising the following steps:
- forming an array of photoactive elements on a support (18) formed with suction openings (56), by the photoactive elements being deposited on the support (18),
- applying a liquid or pasty bonding compound to the array of photoactive elements and
- forming an adhering laminar structure comprising the array of photoactive elements and a plate-like layer, whereby
- the plate-like layer is placed with an arching or curvature onto the array of photoactive elements with the aid of an arching device (17),
- a suction pressure, acting at least in interspaces between the photoactive elements deposited on the support (18), is applied via the suction openings (56), and
- the photoactive elements are embedded in the bonding compound in a bubble-free manner such that at least part of their outer surface is covered by the bonding compound, by the arching of the plate-like layer on the array of photoactive elements with the bonding compound applied thereto being relaxed and the bonding compound being incorporated at least into the interspaces under the suction effect of the suction pressure.

10. Method according to Claim 9, **characterized in that**, as a result of the suction pressure at least in peripheral edge areas of the photoactive elements, the bonding compound enters in a bubble-free manner an area in which the surface of the support and an assigned surface of the photoactive elements lie opposite one another.

11. Method according to Claim 9 or 10, **characterized in that**, when forming the array of photoactive elements, photoactive elements that are contacted on a front side and/or on a rear side are deposited on the support, wherein, in the case of the photoactive elements that are contacted on a front side, contact lines are arranged in surface depressions on the support when the photoactive elements are deposited.

12. Method according to one of Claims 9 to 11, **characterized in that** a standing wave of the bonding compound running over the array of photoactive elements is produced during the relaxation of the arching or curvature of the plate-like layer in an interstice between the array of photoactive elements on the support (18) and the surface of the plate-like layer that is facing the array of photoactive elements.

13. Method according to one of Claims 9 to 12, **characterized in that** a bonding compound comprising silicone or silicone-containing compounds is used as the liquid or pasty bonding compound.

14. Method according to one of Claims 9 to 13, **characterized in that**, when forming the adhering laminar structure, an advancement of a pressure-exerting element (39) along the plate-like layer and a retracting movement of a pressing element (19) are set so as to be coordinated with one another for the controlled relaxation of the arching or curvature.

15. Use of the method according to one of Claims 9 to 14 when producing a multilayered module comprising a number of photoactive elements, in particular a solar module comprising solar cells.

## Revendications

1. Dispositif de fabrication pour modules (1) multicouches (3, 4, 5, 6, 7), notamment modules solaires, ou pour un composant de base multicouches (1') d'un module (1) comprenant une couche en forme de plaque (3, 6) transparente à la lumière et un arrangement d'éléments lumino-actifs (4) avec des espaces intermédiaires entre les éléments lumino-actifs (4), le dispositif de fabrication (2) formant la structure stratifiée et possédant un système d'application (33) pour une masse de jonction (5, 7) liquide ou pâteuse ainsi qu'un dispositif de courbure (17) commandable servant à fléchir une couche en forme de plaque (3, 6), notamment une plaque en verre (3, 6), le dispositif de courbure (17) possédant un appui (18), notamment une table, pour l'arrangement d'éléments lumino-actifs (4) et pour une couche en forme de plaque (3, 6), pourvu d'un serre-flanc du côté du bord ou un dispositif de fixation (20, 46) et d'un élément de compression (19) réglable en hauteur, lesquels viennent en prise au niveau d'une couche en forme de plaque (3, 6), l'appui (18) possédant un dispositif d'aspiration (55) commandable muni d'ouvertures d'aspiration (56) dans la zone d'appui (60) des éléments lumino-actifs (4), les éléments lumino-actifs (4) pouvant être enrobés sans bulles dans la masse de jonction (5, 7) de telle sorte qu'au moins une partie de leur surface extérieure soit recouverte par la masse de jonction (5, 7) et la courbure de la couche en forme de plaque (3, 6) peut être relaxée sur l'arrangement des éléments lumino-actifs (4) sur lesquels est appliquée la masse de jonction (5, 7).

2. Dispositif de fabrication selon la revendication 1, **caractérisé en ce que** le dispositif de courbure (17) produit une courbure ou une cambrure modifiable, notamment relaxable, d'une couche en forme de plaque (3, 6).

3. Dispositif de fabrication selon la revendication 1 ou 2, **caractérisé en ce qu'**un élément de compression (19) est disposé au niveau d'une zone de bord (18') de l'appui (18) et un serre-flanc ou un dispositif de fixation (20, 46) au niveau d'une autre zone de bord (18") de l'appui (18), notamment située à l'opposé.

4. Dispositif de fabrication selon la revendication 1, 2 ou 3, **caractérisé en ce que** le dispositif de courbure (17) possède un élément presseur (39) qui agit sur le côté arrière d'une couche en forme de plaque (3, 6), une avance de l'élément presseur (39) le long de la couche en forme de plaque (3, 6) et un mouvement d'entrée de l'élément de compression (19) du dispositif de courbure (17) étant coordonnés l'un sur l'autre en vue d'une relaxation contrôlée de la courbure de la couche (22).

5. Dispositif de fabrication selon l'une des revendications précédentes, **caractérisé en ce que** pour un élément presseur (39) du dispositif de courbure (17), il existe un dispositif de déplacement (40) avec lequel l'élément presseur (39) peut être déplacé le long d'une couche en forme de plaque (3, 6) et peut en même temps être appuyé contre son verso de couche.

6. Dispositif de fabrication selon l'une des revendications précédentes, **caractérisé en ce qu'**un système d'application (33) possède un dispositif de dosage (44) pour une masse de jonction (5, 7) liquide ou pâteuse.

7. Dispositif de fabrication selon l'une des revendications précédentes, **caractérisé en ce que** le dispositif de fabrication (2) possède un dispositif de chauffage (21) pour les couches (3, 4, 5, 6, 7) du module (1).

8. Dispositif de fabrication selon l'une des revendications précédentes, **caractérisé en ce que** le dispositif de fabrication (2) possède un système d'application (37) pour des couches supplémentaires (6, 7) de l'autre côté d'un composant de base multicouches (1').

9. Procédé de fabrication d'un arrangement de couches comprenant plusieurs éléments lumino-actifs pour un module multicouches, notamment un module solaire, le procédé comprenant les étapes suivantes :
- formation d'un arrangement d'éléments lumino-actifs sur un appui (18) réalisé avec des ouvertures d'aspiration (56) en déposant les éléments lumino-actifs sur l'appui (18),
- application d'une masse de jonction liquide ou pâteuse sur l'arrangement d'éléments lumino-actifs et
- formation d'un composé de couches adhérent avec l'arrangement d'éléments lumino-actifs et une couche en forme de plaque,
- la couche en forme de plaque étant ici appliquée sur l'arrangement d'éléments lumino-actifs à l'aide d'un dispositif de courbure (17) avec une courbure ou une cambrure,
- une pression d'aspiration agissant au moins à l'intérieur d'espaces intermédiaires entre les éléments lumino-actifs déposés sur l'appui (18) étant délivrée par le biais des ouvertures d'aspiration (56), et
- les éléments lumino-actifs étant enrobés sans bulles dans la masse de jonction de telle sorte qu'au moins une partie de leur surface extérieur est recouverte par la masse de jonction, en ce que la courbure de la couche en forme de plaque est relaxée sur l'arrangement des éléments lumino-actifs avec la masse de jonction qui est appliquée sur celui-ci et la masse de jonction est incorporée au moins dans les espaces intermédiaires sous l'effet aspirant de la pression d'aspiration.

10. Procédé selon la revendication 9, **caractérisé en ce que** la masse de jonction, sous l'effet de la pression d'aspiration au moins dans les zones de bordure périphériques des éléments lumino-actifs, parvient sans bulles jusque dans une zone dans laquelle la surface de l'appui et une surface associée des éléments lumino-actifs sont opposées l'une à l'autre.

11. Procédé selon la revendication 9 ou 10, **caractérisé en ce que** lors de la formation de l'arrangement d'éléments lumino-actifs sur l'appui, sont déposés des éléments lumino-actifs avec contact du côté avant et/ou du côté arrière, des lignes de contact étant disposées sur l'appui dans des enfoncements en surface lors de la dépose des éléments lumino-actifs dans le cas des éléments lumino-actifs avec contact du côté avant.

12. Procédé selon l'une des revendications 9 à 11, **caractérisé en ce que** lors de la relaxation de la courbure ou de la cambrure de la couche en forme de plaque, une ondulation fixe de la masse de jonction, s'étendant au-dessus de l'arrangement d'éléments lumino-actifs, est produite dans un gousset entre l'arrangement des éléments lumino-actifs sur l'appui (18) et la surface de la couche en forme de plaque qui fait face à l'arrangement des éléments lumino-actifs.

13. Procédé selon l'une des revendications 9 à 12, **caractérisé en ce que** la masse de jonction liquide ou pâteuse utilisée est une masse de jonction avec des composés de silicone ou contenant du silicone.

14. Procédé selon l'une des revendications 9 à 13, **caractérisé en ce que** lors de la formation du composé de couches adhérent, une avance de l'élément presseur (39) le long de la couche en forme de plaque et un mouvement d'entrée d'un élément de compression (19) sont réglés de manière coordonnée l'un sur l'autre en vue d'une relaxation contrôlée de la courbure ou de la cambrure.

15. Utilisation du procédé selon l'une des revendications 9 à 14 lors de la fabrication d'un module multicouches avec plusieurs éléments lumino-actifs, notamment d'un module solaire muni de cellules solaires.
